(19) Europäisches Patentamt
European Patent Office
Office européen des brevets

(11) Veröffentlichungsnummer: **0 361 173 A1**

# (12) EUROPÄISCHE PATENTANMELDUNG

(21) Anmeldenummer: **89116623.3**

(22) Anmeldetag: **08.09.89**

(51) Int. Cl.5 **G03F 7/027**

(30) Priorität: **17.09.88 DE 3831680**

(43) Veröffentlichungstag der Anmeldung:
**04.04.90 Patentblatt 90/14**

(84) Benannte Vertragsstaaten:
**DE FR GB IT NL**

(71) Anmelder: **BASF Aktiengesellschaft**
**Carl-Bosch-Strasse 38**
**D-6700 Ludwigshafen(DE)**

(72) Erfinder: **Littmann, Dieter, Dr.**
**Neckarpromenade 36**
**D-6800 Mannheim 1(DE)**
Erfinder: **Koch, Horst, Dr.**
**Tiefenthaler Strasse 47**
**D-6718 Gruenstadt(DE)**

## (54) Lichtempfindliches Aufzeichnungsmaterial.

(57) Ein neues lichtempfindliches Aufzeichnungsmaterial für die Herstellung von Druck- oder Reliefformen mit mindestens einer photopolymerisierbaren Aufzeichnungsschicht (A) aus mindestens einem Polymeren als Bindemittel, mindestens einem Photopolymerisationsinitiator, mindestens einer photopolymerisierbaren olefinisch ungesättigten Verbindung (Monomer), welche mit dem polymeren Bindemittel verträglich ist, und/oder photopolymerisierbaren olefinisch ungesättigten Resten, welche seitenständig und/oder endständig mit dem polymeren Bindemittel verknüpft sind, und mindestens einem Hilfsstoff, worin die photopolymerisierbare Aufzeichnungsschicht (A) als Hilfsstoffe zumindest ein oder mehrere Lecithine der allgemeinen Formel I und/oder II

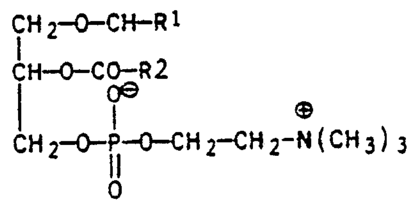

I

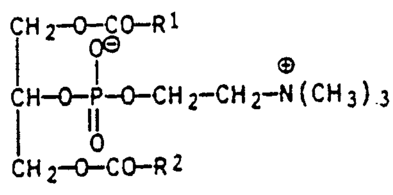

II

in einer Menge von 0,1 bis 10 Gew.-%, bezogen auf die photopolymerisierbare Aufzeichnungsschicht (A), enthält, wobei in den allgemeinen Formeln I und II die Reste $R^1$ und $R^2$ gleich oder voneinander verschieden sein können und eine $C_{11}$- bis $C_{18}$-Alkylgruppe oder $C_{11}$- bis $C_{18}$-Akenylgruppe bedeuten, mit der Maßgabe, daß zumindest einer der Reste $R_1$ oder $R_2$ $C_{11}$- bis $C_{18}$-Alkenyl bedeutet.

EP 0 361 173 A1

## Lichtempfindliches Aufzeichnungsmaterial

Die vorliegende Erfindung betrifft ein lichtempfindliches Aufzeichnungsmaterial für die Herstellung von Druck- oder Reliefformen mit mindestens einer photopolymerisierbaren Aufzeichnungsschicht (A) aus mindestens einem Bindemittel, mindestens einem Photopolymerisationsinitiator, mindestens einer photopolymerisierbaren olefinisch ungesättigten Verbindung (Monomer), welche mit dem Bindemittel verträglich ist, und oder photopolymerisierbaren olefinisch ungesättigten Resten, welche seitenständig und oder endständig mit den polymeren Bindemitteln verknüpft sind, und mindestens einem Hilfsstoff.

Lichtempfindliche Aufzeichnungsmaterialien der eingangs genannten Art sind seit langem bekannt. Für die Herstellung von Druck- oder Reliefformen wird ihre photopolymerisierbare Aufzeichnungsschicht (A) bildmäßig mit aktinischem Licht belichtet, wodurch die belichteten Bereiche photopolymerisiert werden und vernetzte, in den Entwicklerlösungsmitteln unlösliche Schichtbereiche ausbilden. Hiernach werden die unbelichteten Bereiche der bildmäßig belichteten Aufzeichnungsschicht (A) mittels eines geeigneten Entwicklerlösungsmittels unter Erzeugung einer photopolymerisierten Reliefschicht (A′) ausgewaschen.

Aus den bekannten lichtempfindlichen Aufzeichnungsmaterialien hergestellte Reliefschichten (A′), welche eine in der Druckindustrie übliche Reliefstärke von etwa 300 µm bis 1 cm aufweisen, zeigen allerdings meist nicht die gewünschte scharfe Relieffeinstruktur und haben häufig zu kleine Reliefflankenwinkel, was auf eine vergleichsweise hohe Streuung des aktinischen Lichts in der photopolymerisierbaren Aufzeichnungsschicht (A) während der bildmäßigen Belichtung zurückzuführen ist.

Man hat bereits versucht diese Nachteile durch den Zusatz bestimmter, die Reliefstruktur verbessernder Hilfsstoffe, d.h. sogenannter sensitometrischer Regler, zu den photopolymerisierbaren Aufzeichnungsschichten (A) der bekannten lichtempfindlichen Aufzeichnungsmaterialien auszuräumen, zumindest aber zu verringern.

So geht aus der DE-A-27 22 421 ein lichtempfindliches Aufzeichnungsmaterial hervor, dessen photopolymerisierbare Aufzeichnungsschicht (A) zum Zwecke der Reliefstrukturverbesserung 0,001 bis 0,1 Gew.% eines Alkylthioanthrachinons mit bis 12 C-Atomen im Alkylrest in homogener Verteilung enthält. Zwar bringen diese Verbindungen eine gewisse Verbesserung der Reliefstruktur mit sich, doch erfüllen sie noch nicht alle von der Praxis her gestellten Anforderungen. Sie erfordern nicht nur eine sorgfältige Handhabung, sondern stören auch wegen ihrer Eigenfarbe die visuelle Beurteilung der bildmäßig belichteten Aufzeichnungsschicht (A) vor und nach der Entwicklung. Ähnliches gilt für die 10,10′-Bisanthrone und das 9-Nitroanthracen, welche in der DE-A-27 20 599 zur Reliefstrukturverbesserung lichtempfindlicher Aufzeichnungsmaterialien der in Rede stehenden Art empfohlen werden, wie auch für das aus der DE-A-27 20 560 für diesen Zweck vorgeschlagene 9,9′-Dianthronyl. Obwohl bereits vergleichsweise geringe Mengen dieser Verbindungen eine gewisse Verbesserung der Reliefstruktur zur Folge haben, werden hierdurch nicht die sonstigen Nachteile dieser Verbindungen kompensiert. Überdies wird der Effekt der Reliefstrukturverbesserung nicht dadurch weiter verstärkt, daß man höhere Mengen dieser Verbindungen anwendet, sondern es treten im Gegenteil hierdurch die sonstigen Nachteile dieser Verbindungen stärker zu Tage.

Einen deutlichen Fortschritt hat hier die Verwendung der in der DE-A-32 48 247 empfohlenen Kombination aus 0,0001 bis 1 Gew.% eines Phenoxazinium-, Phenazinium-, Acridinium- oder Phenothiaziniumfarbstoffs und 0,005 bis 5 Gew.% eines milden Reduktionsmittels, das den betreffenden Farbstoff nur im angeregten Elektronenzustand zu reduzieren vermag, mit sich gebracht. Allerdings kann es in den lichtempfindlichen Aufzeichnungsmaterialien, welche dieses Farbstoff Reduktionsmittel-System enthalten, bei unsachgemäßer Handhabung zu unerwünschten photoinitiierten Reaktionen in der photopolymerisierbaren Aufzeichnungsschicht (A) kommen, welche das anwendungstechnische Eigenschaftsprofil der Aufzeichnungsmaterialien beeinträchtigen.

Allen bisher bekannten Methoden der Reliefstrukturverbesserung ist die Verwendung stark gefärbter Verbindungen gemeinsam. Diese stark gefärbten Verbindungen werden bei der Entwicklung der bildmäßig belichteten photopolymerisierbaren Aufzeichnungsschichten (A) der lichtempfindlichen Aufzeichnungsmaterialien mit ausgewaschen und verfärben die gebrauchten Entwickler, was deren Wiederverwendung und oder deren umweltgerechte Entsorgung zusätzlich erschwert. Darüber hinaus sind in den letzten Jahren die Ansprüche der Druck- und Elektroindustrie an die Qualität der mittels photopolymerisierbarer Aufzeichnungsschichten (A) hergestellten Druck- und Reliefformen stetig gewachsen, was eine fortlaufende Weiterentwicklung der Methoden zur Reliefstrukturverbesserung erzwingt.

Es ist auch bereits bekannt, Lecithine im Zusammenhang mit der Bilderzeugung mittels lichtempfindlicher Aufzeichnungsmaterialien zu verwenden.

So gehen aus der US-A-3 585 031 sowie der CA-A-945 800 zahlreiche Abbildungsverfahren hervor, welche mit Hilfe von Schichten aus Lecithin (actinic radiation sensitive phosphatide compounds) ausgeführt

werden. Diese Abbildungsverfahren nutzen die Eigenschaften der Lecithinschichten, bei der bildmäßigen Belichtung mit aktinischem Licht (UV-Licht, β-Strahlung, Röntgenstrahlung) latente Bilder zu liefern. Diese latenten Bilder können dann in der unterschiedlichsten Art und Weise entwickelt werden, so daß sie haltbare Einzelkopien liefern oder für die Herstellung von Mehrfachkopien geeignet sind.

So kann das durch die bildmäßige Belichtung mit aktinischem Licht in einer Lecithinschicht erzeugte latente Bild beispielsweise durch Erhitzen, durch die Lagerung im Dunkeln während 1 bis 7 Tagen oder durch Eintauchen in eine wäßrige Kupfer/Ammoniumchlorid-Lösung sichtbar gemacht werden. Des weiteren kann ein sichtbares Bild durch Eintauchen des latenten Bildes in eine wäßrige Kaliumiodidlösung erhalten werden. Die in den bildmäßig belichteten Bereichen der Lecithinschichten enthaltenen Peroxide setzen hierbei aus der Kaliumiodidlösung Iod frei, wodurch ein deutlich sichtbares Bild resultiert.

Es ist auch bereits bekannt, durch die Peroxide in den bildmäßig belichteten Bereichen der Lecithinschichten die bildmäßige Polymerisation in radikalisch polymerisierbaren Aufzeichnungsschichten zu initiieren. Hierzu wird eine bildmäßig belichtete Lecithinschicht einer radikalisch polymerisierbaren Aufzeichnungsschicht, z.B. aus Diethylenglykol-dimethacrylat und Cellulose-acetat-succinat oder Polyestern aus Polyolen und α,β-olefinisch ungesättigten α,β-olefinisch ungesättigten α,β-Dicarbonsäuren, direkt aufgelegt, wonach die Peroxide der Lecithinschicht die radikalische Polymerisation in der darunter liegenden radikalisch polymerisierbaren Aufzeichnungsschicht initiieren. Diese Polymerisation kann durch Erhitzen beschleunigt werden. Es handelt sich somit hierbei um eine reine thermisch initiierte radikalische Polymerisation, welche in photopolymerisierbaren Aufzeichnungsschichten (A) strikt vermieden werden muß, weil ansonsten deren Wiedergabequalität drastisch bis hin zur völligen Unbrauchbarkeit verschlechtert wird.

Darüber hinaus kann das latente Bild in einer Lecithinschicht auch dadurch sichtbar gemacht werden, daß man die bildmäßig belichtete Lecithinschicht zunächst mit einem unpolaren hochschmelzenden Wachs beschichtet und danach über den Schmelzpunkt des Wachses hinaus erhitzt. Durch das Erhitzen werden die bildmäßig belichteten Bereiche des latenten Bildes hydrophil, wogegen seine nicht belichteten Bereiche hydrophob bzw. oleophil werden.

Das geschmolzene Wachs fließt von den hydrophilen Bereichen weg und sammelt sich in den hydrophoben oleophilen Bereichen an. Nach dem Abkühlen resultiert so ein Wachsrelief auf der Oberfläche der Lecithinschicht. Diese bildmäßige Differenzierung der Lecithinoberfläche kann auch im entgegengesetzten Sinne genutzt werden, indem man anstelle eines hydrophoben Wachses eine hochschmelzende wasserlösliche Substanz verwendet, welche sich in den hydrophilen Bereichen ansammelt. Hierfür kommen z.B. Sorbit, Dextrose, Polyvinylacetat oder Polyvinylalkohol in Betracht. Über die Verwendung und die Wirkungsweise von Lecithinen in photopolymerisierbaren Aufzeichnungsschichten (A) ist weder der US-A-3 585 031 noch der CA-A-945 800 irgend etwas zu entnehmen.

Ein weiteres Abbildungsverfahren, bei welchem Lecithin verwendet wird, ist aus der DE-A-21 46 779 bekannt. Bei diesem Abbildungsverfahren wird eine lichtempfindliche Schicht verwendet, die bei der bildmäßigen Belichtung mit aktinischem Licht, je nach ihrer stofflichen Zusammensetzung, entweder in ihren belichteten Bereichen klebrig wird, so daß ätzende Pulver hieran haften bleiben (negativ wirkende Schicht), oder in ihren belichteten Bereichen gehärtet wird, so daß diese die ätzenden Pulver nicht festhalten, wogegen die nicht belichteten Bereiche klebrig bleiben (positiv wirkende Schicht).

Gemäß der DE-A-21 46 779 werden für den Aufbau positiv wirkender Schichten Sojalecithin, partiell hydriertes Lecithin oder Dilinolenyl-α-Lecithin (Filmbildner) in Verbindung mit dem 0,001 bis 2-fachen, insbesondere 0,001 bis 0,8-fachen, des Gewichts des Filmbildners an Photoinitiatoren, wie Acyloinen oder vicinalen Diketonen, empfohlen. Darüber hinaus können noch Farbstoffe als Coinitiatoren sowie übliche und bekannte Weichmacher zur Verbesserung der filmbildenden Eigenschaften mitverwendet werden. Durch die Erhöhung des Gehalts an Photoinitiatoren auf mindestens das 1-fache des Gewichts des Filmbildners werden die positiv wirkenden Schichten in negativ wirkende umgewandelt. Nach der bildmäßigen Belichtung dieser hochempfindlichen Schichten mit aktinischem Licht werden die ätzenden Pulver aufgetragen und bleiben entweder in den belichteten oder in den unbelichteten Bereichen der Schichten haften. Hiernach werden die nicht haftenden Anteile der ätzenden Pulver entfernt, wodurch Muster aus ätzenden Pulvern gemäß der ursprünglichen Bildvorlage resultieren. Die ätzenden Pulver oder die darin enthaltenen ätzenden Wirkstoffe werden dann in unterschiedlichster Weise mit den unter den lichtempfindlichen Schichten liegenden, zu ätzenden schichtförmigen Materialien in Berührung gebracht, wodurch letztlich ein geätztes Muster in diesen schichtförmigen Materialien resultiert.

Eine Variante dieses Verfahrens, gemäß der Eisen(III)chlorid als besonders bevorzugter Photoaktivator für Lecithine verwendet wird, geht aus der ZA-A-70/0384 hervor.

Weder der DE-A-21 46 779 noch der ZA-A-70/0384 sind Hinweise zu entnehmen, die dazu anregen könnten, Lecithine in photopolymerisierbaren Aufzeichnungsschichten (A) zum Zwecke der Reliefstrukturverbesserung zu verwenden. Im Gegenteil lassen die zahlreichen unterschiedlichen Reaktionsweisen der

Lecithine, insbesondere aber ihre Neigung zur Peroxidbildung oder ihre nachträgliche Veränderung nach der bildmäßigen Belichtung mit aktinischem Licht, befürchten, daß ihre Verwendung in photopolymerisierbaren Aufzeichnungsschichten (A) keinen nützlichen technischen Effekt, sondern eher schwerwiegende Nachteile mit sich bringt.

Aufgabe der vorliegenden Erfindung ist es, ein neues lichtempfindliches Aufzeichnungsmaterial mit mindestens einer photopolymerisierbare Aufzeichnungsschicht (A) aus mindestens einem polymeren Bindemittel, mindestens einem Photopolymerisationsinitiator, mindestens einer photopolymerisierbaren olefinisch ungesättigten Verbindung (Monomer), welche mit dem Bindemittel verträglich ist, und/oder photopolymerisierbaren olefinisch ungesättigten Resten, welche seitenständig und/oder endständig mit den polymeren Bindemitteln verknüpft sind, und mindestens einem Hilfsstoff aufzuzeigen, welches die Herstellung von Druck- und Reliefformen mit gut ausgeprägter Reliefstruktur auch bei sehr feinen Bildelementen vorlagengetreu gestattet.

Das neue lichtempfindliche Aufzeichnungsmaterial soll außerdem die Nachteile des Standes der Technik nicht mehr länger aufweisen. Insbesondere soll es nach seiner bildmäßigen Belichtung mit aktinischem Licht und seiner Entwicklung zu Druck- und Reliefformen mit verbesserter Reliefstruktur führen.

Es wurde nun insbesondere gefunden, daß diese Aufgabe durch lichtempfindliche Aufzeichnungsmaterialien mit mindestens einer photopolymerisierbaren Aufzeichnungsschicht (A) der in Rede stehenden Art gelöst wird, welche in ihrer photopolymerisierbaren Aufzeichnungsschicht (A) ein oder mehrere Lecithine der nachfolgend näher beschriebenen Art als Hilfsstoffe enthalten.

Gegenstand der Erfindung sind dementsprechend neue lichtempfindliche Aufzeichnungsmaterialien für die Herstellung von Druck- oder Reliefformen mit mindestens einer photopolymerisierbaren Aufzeichnungsschicht (A) aus

($a_1$) mindestens einem Polymeren als Bindemittel

($a_2$) mindestens einem Photopolymerisationsinitiator,

($a_3$) mindestens einer photopolymerisierbaren olefinisch ungesättigten Verbindung (Monomer), welche mit dem polymeren Bindemittel ($a_1$) verträglich ist, und/oder photopolymerisierbaren olefinisch ungesättigten Resten, welche seitenständig und/oder endständig mit dem polymeren Bindemittel ($a_1$) verknüpft sind, und

($a_4$) mindestens einem Hilfsstoff,

welche dadurch gekennzeichnet sind, daß ihre photopolymerisierbaren Aufzeichnungsschichten (A) als Hilfsstoffe ($a_4$) zumindest

($a_{41}$) ein oder mehrere Lecithine der allgemeinen Formel I und/oder II

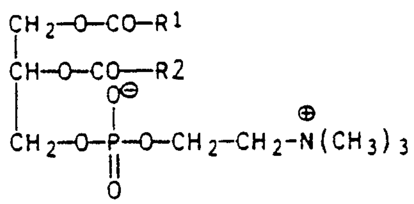

I

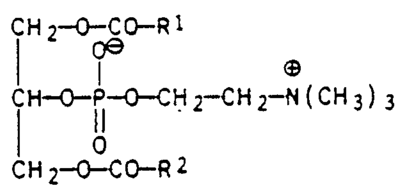

II

in einer Menge von 0,1 bis 10 Gew.%, bezogen auf die photopolymerisierbare Aufzeichnungsschicht (A), enthalten, wobei in den allgemeinen Formeln I und II die Reste $R^1$ und $R^2$ gleich oder voneinander verschieden sein können und eine $C_{1}$- bis $C_{3}$-Alkylgruppe oder $C$- bis $C_{3}$-Alkenylgruppe bedeuten, mit der Maßgabe, daß zumindest einer der Reste $R_1$ oder $R_2$ eine $C$- bis $C_{3}$-Alkenylgruppe bedeutet.

Im Rahmen der vorliegenden Erfindung zeigt der Begriff "verträglich" generell an, daß der betreffende Bestandteil in der photopolymerisierbaren Aufzeichnungsschicht (A) molekulardispers und/oder ohne Trübung oder Schlieren hervorzurufen verteilt werden kann und sich auch im Laufe der Zeit nicht entmischt.

Unter "Hilfsstoffen" sind hier Verbindungen zu verstehen, mit denen ganz allgemein eine gezielte Variation - üblicherweise eine Verbesserung - anwendungstechnischer Eigenschaften lichtempfindlicher Aufzeichnungsschichten, insbesondere photopolymerisierbarer Aufzeichnungsschichten (A) erreicht wird.

Diese Verbesserungen manifestieren sich vor allem in Reliefplatten, Hochdruck-, Flexodruck- und Tiefdruckplatten sowie in Photoresists, welche man aus den lichtempfindlichen Aufzeichnungsschichten, die diese Hilfsstoffe enthalten, hergestellt hat.

Druckformen sind z.B. Hochdruck-, Flexodruck-, Offsetdruck- und Tiefdruckformen. Druckformen werden häufig auch als Druckplatten bezeichnet.

Reliefformen sind z.B. bildmäßig strukturierte Photoresistschichten und dekorative Reliefs.

Das erfindungsgemäße, neue lichtempfindliche Aufzeichnungsmaterial für die Herstellung von Druck- oder Reliefformen, welches mindestens eine photopolymerisierbare Aufzeichnungsschicht (A) aufweist, wird im folgenden der Kürze halber als "erfindungsgemäßes Aufzeichnungsmaterial" bezeichnet.

Der wesentliche Bestandteil der erfindungsgemäßen Aufzeichnungsmaterialien ist ihre neue photopolymerisierbare Aufzeichnungsschicht (A).

Die erfindungsgemäß wesentlichen Bestandteile der neuen photopolymerisierbaren Aufzeichnungsschicht (A) sind die Hilfsstoffe ($a_{41}$), d.h. die Lecithine I und/oder II. Lecithine sind eine spezielle Gruppe von Phospholipiden, bei denen die Phosphorsäure einerseits mit Cholin und andererseits mit Glycerin verestert wird. Werden dessen freien Hydroxylgruppen mit langkettigen Fettsäuren verestert, so erhält man Phosphatidylcholine (Lecithine). In der Natur kommen fast ausschließlich die Lecithine I vor, welche auch als $\alpha$-Lecithine bezeichnet werden. Demgegenüber kommen die Lecithine II, auch $\beta$-Lecithine genannt, nur selten als Naturprodukte vor.

Erfindungsgemäß ist in der neuen photopolymerisierbaren Aufzeichnungsschicht (A) der erfindungsgemäßen Aufzeichnungsmaterialien mindestens ein Lecithin I oder II enthalten. Oder aber es sind in der neuen photopolymerisierbaren Aufzeichnungsschicht (A) mindestens ein Lecithin I und mindestens ein Lecithin II enthalten. Hierbei sind die Lecithine I und/oder II die alleinigen Hilfsstoffe ($a_{41}$), oder aber es sind außer den obligatorisch vorhandenen Lecithinen I und/oder II (Hilfsstoffe $a_{41}$) noch weitere sonstige Hilfsstoffe ($a_4$) zugegen.

Unabhängig davon, ob die Lecithine I und/oder II alleine oder gemeinsam mit anderen Hilfsstoffen ($a_4$) angewandt werden, sind sie in einer Menge von 0,1 bis 10 Gew.% in der neuen photopolymerisierbaren Aufzeichnungsschicht (A) enthalten. Hierbei empfiehlt es sich im allgemeinen nicht, den Anteil der Lecithine I und/oder II in der neuen photopolymerisierbaren Aufzeichnungsschicht (A) über 10 Gew.% hinaus zu erhöhen, weil es hierbei unter gewissen Umständen zu unerwünschten Nebenreaktionen in der neuen photopolymerisierbaren Aufzeichnungsschicht (A) bei deren Lagerung und/oder bei oder nach deren bildmäßigen Belichtung kommen kann. Dagegen soll im allgemeinen der Anteil der Lecithine I und/oder II an der neuen photopolymerisierbaren Aufzeichnungsschicht (A) 0,1 Gew.% nicht unterschreiten, weil ansonsten die durch die Lecithine I und/oder II hervorgerufenen technischen Effekte nicht immer den Ansprüchen der Praxis in vollem Umfang gerecht werden. Demgemäß handelt es sich bei dem Bereich von 0,1 bis 10 Gew.% ~~um ein~~ Optimum, innerhalb dessen der Anteil der Lecithine I und/oder an der neuen photopolymerisierbaren Aufzeichnungsschicht (A) variiert und der jeweils verwendeten photopolymerisierbaren Aufzeichnungsschicht (A) angepaßt wird. Innerhalb dieses optimalen Bereichs ist derjenige von 0,5 bis 5 Gew.% bevorzugt, weil neue photopolymerisierbare Aufzeichnungsschichten (A) mit einem solchen Gehalt an Lecithinen I und/oder II besonders vorteilhaft sind und Reliefschichten ($A'$) mit ausgezeichneter Reliefstruktur liefern. Aus diesem erfindungsgemäß besonders bevorzugten Bereich ist wiederum derjenige von 0,8 bis 4 Gew.% hervorzuheben, weil aus einem solchen Anteil an Lecithinen I und/oder II ein ganz besonders vorteilhaftes anwendungstechnisches Eigenschaftsprofil der betreffenden neuen photopolymerisierbaren Aufzeichnungsschichten (A) resultiert. Dies bedeutet, daß dieser Anteil an Lecithinen I und/oder II hinsichtlich des Materialaufwandes einerseits und des hiermit erzielten technischen Effekts andererseits hervorragend ausgewogen und daher erfindungsgemäß ganz besonders bevorzugt ist.

Die erfindungsgemäß zu verwendenden Lecithine I und/oder II enthalten die Reste $R^1$ und $R^2$. Hierbei bezeichnen die Reste $R^1$ und $R^2$ $C_{11}$- bis $C_{18}$-Alkylreste wie Undecan-1-yl, Dodecan-1-yl, Tridecan-1-yl, Tetradecan-1-yl, Pentadecan-1-yl, Hexadecan-1-yl, Heptadecan-1-yl oder Octadecan-1-yl.

Oder die Reste $R^1$ und $R^2$ bezeichnen $C_{11}$- bis $C_{18}$-Alkenylreste wie Undec-2-, -3-, -4-, -5-, -6-, -7-, -8-, -9- oder -10-en-1-yl; Undec-3,6-, -4,7- oder -7,10-dien-1-yl; Dodec-2-, -3-, -4-, -5-, -6-, -7-, -8-, -9-, -10- oder -11-en-1-yl; Dodec-3,6- oder -6,11-dien-1-yl; Tridec-2-, -3-, -4-, -5-, -6-, -7-, -8-, -9-, -10-, -11- oder -12-en-1-yl; Tride-4,7, 10-trien-1-yl; Tetradec-2-, -3-, -4-, -5-, -6-, -7-, -8-, -9-, -10-, -11-, -12- oder -13-en-1-yl; Tetradec-4,10- oder -5,8-dien-1-yl; Pentadec-2-, -3-, -4-, -5-, -6-, -7-, -8-, -9-, -10-, -11-, -12-, -13- oder -14-en-1-yl; Hexadec-2-, -3-, -4-, -5-, -6-, -7-, -8-, -9-, -10-, -11-, -12-, -13-, -14- oder -15-en-1-yl; Heptadec-2-, -3-, -4-, -5-, -6-, -7-, -8-, -9-, -10-, -11-, -12-, -13-, -14-, -15- oder -16-en-1-yl; Heptadec-8,11-dien-1-yl; Heptadec-8,10,12- oder -8,11,14-trien-1-yl; Octadec-2-, -3-, -4-, -5-, -6-, -7-, -8-, -9-, -10-, -11-, -12-, -13-, -14-, -15-, -16- oder -17-en-1-yl; oder Octadec-6,15-, -7,10- oder -9,11-dien-1-yl. Dabei sind die Reste $R^1$ und $R^2$ voneinander verschieden oder gleich. Sofern sie voneinander verschieden sind, bezeichnet zumin-

dest ein Rest R' oder $R^2$ einen $C_{11}$- bis $C_{13}$-Alkenylrest. Sofern die Reste $R^1$ und $R^2$ gleich sind, handelt es sich bei den Resten R' und $R^2$ stets um zwei identische Alkenylreste aus der Gruppe der $C_{11}$- bis $C_{18}$-Alkenylreste. Dies bedeutet, daß die erfindungsgemäß zu verwendenden Lecithine I und/oder II immer einen olefinisch ungesättigten Rest R' oder $R^2$ oder zwei olefinisch ungesättigte Reste R' und $R^2$ enthalten.

Von den vorstehend genannten Resten R' und $R^2$ sind Undecan-1-yl, Tridecan-1-yl, Pentadecan-1-yl, Heptadecan-1-yl, cis-Heptadec-8-en-1-yl, Heptadec-8,11-dien-1-yl und Heptadec-8,11,14-trien-1-yl, welche sich von der Laurin-, Myristin-, Palmitin-, Stearin-, Öl-, Linol- und Linolensäure ableiten, besonders vorteilhaft. Die Lecithine I und/oder II, welche diese Reste aufweisen, sind daher erfindungsgemäß besonders bevorzugt. Ganz besonders bevorzugt sind hierbei die betreffenden, in der Natur vorkommenden Lecithine I, weil diese die Reste R' und/oder $R^2$ in ganz besonders vorteilhaften Kombinationen enthalten. Aus diesen natürlichen Lecithinen I ist Sojalecithin hervorzuheben, weil es in den neuen photopolymerisierbaren Aufzeichnungsschichten (A) der erfindungsgemäßen Aufzeichnungsmaterialien einen ganz besonders vorteilhaften technischen Effekt bewirkt.

Die neue photopolymerisierbare Aufzeichnungsschicht (A) enthält, bezogen auf ihre Gesamtmenge, 10 bis 99, vorzugsweise 25 bis 95 und insbesondere 30 bis 90 Gew.% eines oder mehrerer Polymeren als Bindemittel ($a_1$), wobei für diesen Verwendungszweck alle die Polymeren in Betracht kommen, welche in Entwicklerlösungsmitteln löslich oder quellbar sind, sich mit den übrigen Bestandteilen der neuen photopolymerisierbaren Aufzeichnungsschicht (A) vermischen lassen und mit diesen verträglich sind. Beispiele geeigneter Polymere bzw. Bindemittel ($a_1$) sind Polyamide, Copolyamide, Polyester, Polyurethane, Polyvinylalkohole, Polyalkadiene, Vinylaromat/Alkadien-Copolymerisate und -Blockmischpolymerisate, Alkadien/Acrylnitril-Copolymerisate, Butylkautschuke, Acrylatkautschuke, Polychloroprene, Fluorkautschuke, Polysulfidkautschuke, Silikonkautschuke, Ethylen/Propylen- und Ethylen/Propylen/Alkadien-Kautschuke, chlorsulfonierte Polyethylene, Ethylen/(Meth)Acrylat-, Ethylen/Vinylacetat- und Ethylen/(Meth)Acrylsäure-Copolymerisate und (Meth)Acrylsäure/(Meth)Acrylat-Copolymerisate.

Diese als Bindemittel ($a_1$) geeigneten Polymere sind bekannte Verbindungen und werden durch übliche und bekannte Methoden der Polymerchemie hergestellt.

Besonders vorteilhafte Bindemittel ($a_1$) entstammen den Polymerklassen der Polyamide, Copolyamide, Polyvinylalkohole, Polyalkadiene, Vinylaromat/Alkadien-Copolymerisate und -Blockmischpolymerisate, Alkadien/Acrylnitril-Copolymerisate, Ethylen/Propylen/Alkadien-Kautschuke und der Ethylen/(Meth)-Acrylsäure-Copolymerisate, bzw. werden aus dieser Gruppe für die Verwendung ausgewählt.

Beispiele besonders vorteilhafter Bindemittel ($a_1$) aus der Polymerklasse der Polyamide und Copolyamide sind lineare Homo- und Copolyamide, die in bekannter Weise aus bifunktionellen Carbonsäuren und Diaminen oder aus ω-Aminosäuren, Lactamen oder aus geeigneten Derivaten dieser Verbindungen hergestellt werden, wie Nylon 3, 4, 5, 6, 8, 11, 12, 13, 6.6., 6.10 oder 6.13; oder ein Polyamid aus Metaxylylendiamin und Adipinsäure oder aus Trimethyl-hexamethylendiamin oder Isophorondiamin und Adipinsäure; oder Nylon 6/6.6, 6/6.6/6.10 oder 6/6.6/6.10/6.12; oder ein Polyamid aus ε-Caprolactam/Adipinsäure/Hexamethylendiamin/4, 4-Diaminodicyclohexylmethan oder aus ε-Caprolactam/Adipinsäure/Hexamethylendiamin/Polyethylenglykoldiamin; oder die N-Methylol- oder N-Alkoximethylderivate all dieser Homo- und Copolyamide; oder Homo- und Copolyamide der genannten Art, welche photopolymerisierbare olefinisch ungesättigte Reste ($a_3$) enthalten.

Beispielse besonders vorteilhafter Bindemittel ($a_1$) aus der Polymerklasse der Polyvinylalkohole sind die in Wasser löslichen oder dispergierbaren Polyvinylalkohole, welche wiederkehrende 1-Hydroxy-ethyliden-1,2-Einheiten

$$-CH_2-\underset{\displaystyle OH}{\underset{|}{C}}H-$$

in der Polymerkette enthalten und zahlenmittlere Molgewichte $\overline{M}_n$ von $10^4$ bis $10^5$, insbesondere $1{,}5 \cdot 10^4$ bis $5 \cdot 10^4$ aufweisen, beispielsweise partiell oder nahezu vollständig hydrolysiertes Polyvinylacetat oder -propionat mit einem Hydrolysegrad von 60 bis 100 %, vorzugsweise 70 bis 99 % und insbesondere 75 bis 95 %. Von besonderem Vorteil sind auch die partiell oder nahezu vollständig hydrolysierten Vinylalkohol-alkancarbonsäureester/Alkylenoxid-Pfropfmischpolymerisate ($a_1$), insbesondere solche, die durch Pfropfen von Vinylacetat oder -propionat auf Polyethylenoxid und anschließende Hydrolyse erhalten werden und aus - jeweils bezogen auf das Pfropfmischpolymerisat ($a_1$) -

10 bis 30 Gew.% an 1-Oxapropyliden-1,3-,

$-O-CH_2-CH_2-$

0 bis 30 Gew.% an 1-Acetyl-ethyliden-1,2-

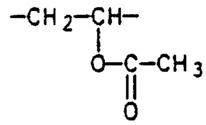

und 90 bis 40 Gew.% an 1-Hydroxyethyliden-1,2-Einheiten bestehen.

Diese Polyvinylalkohole ($a_1$) können, bezogen auf die ursprünglich in den Polyvinylalkoholen vorhandenen Hydroxylgruppen, 0,1 bis 10, vorzugsweise 0,5 bis 8 und insbesondere 1 bis 6 Mol.% der durch übliche und bekannte polymeranaloge Umsetzungen eingeführten seitenständigen Alkencarbonsäureesterreste wie Acryl-, Methacryl- oder Maleinsäureesterreste; oder der Alkencarbonylamino-N-methylenetherreste wie Acryl- oder Methacrylamido-N-methylenetherreste; (= photopolymerisierbare olefinisch ungesättigte Reste ($a_3$)) enthalten. Diese photopolymerisierbaren olefinisch ungesättigten Reste ($a_3$) können auch in den anderen Bindemitteln ($a_1$) enthalten sein.

Beispiele besonders vorteilhafter Bindemittel ($a_1$) aus der Polymerklasse der Alkadiene sind Naturkautschuk, die Homopolymerisate von Butadien oder Isopren, Butadien/Isopren-Copolymerisate oder die entsprechenden Polymerisate mit photopolymerisierbaren olefinisch ungesättigten Resten ($a_3$).

Beispiele besonders vorteilhafter Bindemittel ($a_1$) aus der Polymerklasse der Vinylaromat/Alkadien-Copolymerisate sind Copolymerisate aus Styrol und Butadien und/oder Isopren mit statistischer Verteilung der einpolymerisierten Monomeren und einem Gehalt an einpolymerisiertem Styrol von vorzugsweise 10 bis 50 Gew.% oder die entsprechenden Copolymerisate mit photopolymerisierbaren olefinisch ungesättigten Resten ($a_3$).

Beispiele besonders vorteilhafter Bindemittel ($a_1$) aus der Polymerklasse der Vinylaromat/Alkadien-Blockmischpolymerisate sind diejenigen, welche mindestens einen elastomeren Dien-Polymerisatblock X und mindestens einen thermoplastischen Vinylaromaten-Polymerisat-Block Y enthalten, wobei die Blöcke X und Y im allgemeinen über Kohlenstoff-Kohlenstoff-Bindungen chemisch miteinander verknüpft sind. In einem gegebenen Blockcopolymerisat kann die Verknüpfung von einem Block X mit einem Block Y auch durch ein statistisches oder ein alternierendes Copolymeres, welches konjugierte Diene und Vinylaromaten einpolymerisiert enthält, erfolgen; oder aber die Verknüpfung der Blöcke X und Y erfolgt mittels eines Copolymerisats aus konjugierten Dienen und Vinylaromaten, in welchem die Konzentration einpolymerisierter konjugierter Diene vom Block X zum Block Y hin ab- und die Konzentration einpolymerisierter Vinylaromaten zunimmt.

Darüber hinaus können die Blockmischpolymerisate über geeignete mehrbindige Atome oder Ionen sowie anorganische, organische oder metallorganische Molekülreste zu noch größeren Blockmischpolymerisat-Verbänden verknüpft werden. Dabei ist unter Verknüpfung die Bildung kovalenter oder ionischer Bindungen zwischen zwei Molekülresten zu verstehen.

Außerdem können die olefinischen und aromatischen Bindungen oder auch nur die olefinischen Bindungen in den Dienpolymerisat-Blöcken X partiell oder vollständig hydriert vorliegen. Zudem können die Blöcke X und Y weitere Monomere, bei welchen es sich nicht um konjugierte Diene und Vinylaromaten handeln muß, einpolymerisiert enthalten, wie beispielsweise Acrylnitril, Acrylsäure, Maleinsäureanhydrid, (Meth)Acrylsäureamide oder (Meth)acrylsäureester, wobei deren Anteil am Blockmischpolymerisat im allgemeinen 10 Gew.% nicht übersteigen soll. Dabei können die Blöcke X auch Vinylaromaten einpolymerisiert enthalten, wobei deren Menge so gewählt wird, daß sie die elastomeren Eigenschaften der Blöcke X nicht beeinträchtigt. Ebenso können die Blöcke Y so viele konjugierte Diene einpolymerisiert enthalten, daß ihre thermoplastische Verarbeitbarkeit nicht verloren geht. Überdies können die Blockmischpolymerisate photopolymerisierbare Reste ($a_3$) enthalten.

Enthält dabei ein Blockmischpolymerisat mehrere elastomere Blöcke X und/oder mehrere thermoplastische Blöcke Y, dann müssen die Blöcke X bzw. Y nicht jeweils chemisch identisch oder angenähert gleich sein, sondern sie können sich jeweils deutlich voneinander unterscheiden, sofern sie stets die erforderlichen elastomeren bzw. thermoplastischen olefinisch ungesättigte Eigenschaften aufweisen.

Im allgemeinen weisen Blöcke X eine Glastemperatur Tg von unterhalb 20 °C, vorzugsweise unterhalb 0 °C und insbesondere unterhalb -15 °C auf. Diese Blöcke können im allgemeinen eine mittlere Molmasse von $10^3$ bis $2.10^5$ aufweisen. Im allgemeinen enthalten sie 30 bis 100, insbesondere 30 bis 95 Gew.%, bezogen auf den jeweiligen Block X, an einpolymerisierten konjugierten Dienen.

Blöcke Y weisen im allgemeinen eine Glastemperatur Tg von mehr als 20 °C auf. Sie haben im allgemeinen eine mittlere Molasse von $1,5.10^3$ bis $2.10^6$, vorzugsweise $5.10^3$ bis $1,5.10^6$ und insbesondere $10^4$ bis $1,2.10^5$. Sie enthalten im allgemeinen 30 bis 100, insbesondere 40 bis 90 Gew.%, bezogen auf den jeweiligen Block Y, an einpolymerisierten Vinylaromaten.

Beispiele für vorteilhafte konjugierte Diene sind Butadien, Isopren, Pentan-1,3-dien, 2,3-Dimethylbutadien oder Hexan-2,4-dien, wobei Butadien und/oder Isopren bevorzugt sind.

Beispiele für vorteilhafte Vinylaromaten sind Styrol, α-Methylstyrol, p-Methylstyrol, p-tert.-Butylstyrol oder 1-Vinylnaphthalin, wobei Styrol bevorzugt ist.

Als Beispiele für besonders vorteilhafte Blockmischpolymerisate seien die thermoplastisch elastomeren Dreiblockmischpolymerisate Y-X-X′ angeführt, in denen Y einen thermoplastischen, nicht elastischen Styrolpolymerisat-Block, X einen elastomeren Butadien- und/oder Isoprenpolymerisat-Block und X′ einen von X verschiedenen elastomeren Polymerisat-Block aus einpolymerisiertem Butadien und/oder Isopren sowie gegebenenfalls einpolymerisiertem Styrol darstellt.

Als weitere Beispiele für besonders vorteilhafte Blockmischpolymerisate seien Vierblockmischpolymerisate, wie X-Y-X-Y, Y-X-X′-Y, Y-X-Y-X′ oder X-X′-Y-X angeführt.

Beispiele besonders vorteilhafter Bindemittel ($a_1$) aus der Polymerklasse der Alkadien/Acrylnitril-Copolymerisate sind die Nitrilkautschuke, wie Butadien/Acrylnitril-Copolymerisate mit einem Acrylnitrilgehalt von 15 bis 40 Gew.%, oder Nitrickautschuke der genannten Art mit photopolymerisierbaren Resten ($a_3$).

Beispiele besonders vorteilhafter Bindemittel ($a_1$) aus der Polymerklasse der Ethylen/Propylen/Alkadien-Kautschuke, welche auch als "EPDM-Kautschuke bezeichnet werden, sind

- Ethylen-Propylen-Dicyclopentadien-,
- Ethylen-Propylen-Ethylidennorbornen-,
- Ethylen-Propylen-trans-Hexa-1,4-dien-,
- Ethylen-Propylen-Dicyclopentadien-Ethylidennorbornen-,
- Ethylen-Propylen-Dicyclopentadien-trans-Hexa-1,4-dien-,
- Ethylen-Propylen-Ethylidennorbornen-trans-Hexa-1,4-dien- oder
- Ethylen-Propylen-Ethylidennorbornen-Dicyclopentadien-trans-Hexa-1,4-dien-Terpolymerisate ($a_1$),

welche 40 bis 86 Gew.% Ethylen und soviel der Alkadiene einpolymerisiert enthalten, daß sich ein Doppelbindungsanteil von 2 bis 20 olefinischen Doppelbindungen je 1000 Kohlenstoffatome ergibt, oder die EPDM-Kautschuke der genannten Art mit photopolymerisierbaren Resten ($a_3$).

Beispiele besonders vorteilhafter Bindemittel ($a_1$) aus der Polymerklasse der Ethylen/(Meth)Acrylsäure-Copolymerisate sind diejenigen, welche durch Copolymerisation von Monomerengemischen erhältlich sind, die aus

$a_{11}$) Ethylen,

$a_{12}$) Acrylsäure und/oder Methacrylsäure und aus

$a_{13}$) Vinylester, Vinylether, Acrylsäureester, Methacrylsäureester, Acrylsäureamide und Methacrylsäureamide bestehen und für deren Gewichtsverhältnisse die folgenden Bedingungen gelten:

Gew.-Teile ($a_{11}$) + ($a_{12}$) + ($a_{13}$) = 100,

30 Gew.-Teile ≦ Gew.-Teile ($a_{11}$) ≦ 70 Gew.-Teile,

5 Gew.-Teile ≦ Gew.-Teile ($a_{12}$) ≦ 50 Gew.-Teile und

5 Gew.-Teile ≦ Gew.-Teile ($a_{13}$) ≦ 40 Gew.-Teile.

Ihre Darstellung kann z.B. nach der LDPE (= low density polyethylene)-Hochdruckpolymerisations-Methode bei Temperaturen von 200 bis 400 °C und einem Druck von mehr als 800 kg/cm² erfolgen [s. z.B. DE-B-23 41 462 und US-A-3 264 272].

Als Comonomere ($a_{13}$) geeignete Vinylester sind hierbei insbesondere solche der allgemeinen Formel III

$$CH_2=CH-\overset{\overset{\displaystyle O}{\|}}{C}-R^3 \qquad III,$$

worin $R^3$ einen Alkyl- oder Cycloalkylrest mit 1 bis 10 C-Atomen bedeutet, z.B. Vinylacetat, Vinylpropionat, Vinylbutyrat, Valeriansäurevinylester oder Hexancarbonsäurevinylester. Bevorzugt ist Vinylacetat.

Als Comonomere ($a_{13}$) geeignete Vinylether sind hierbei insbesondere solche der allgemeinen Formel IV

$$CH_2=CH-OR^3 \qquad IV,$$

worin $R^3$ die oben angegebene Bedeutung hat, z.B. Vinylethylether, Vinyl-1-propylether, Vinyl-2-propylether, Vinyl-1-butylether, Vinyl-2-butylether oder Vinyl-1-pentylether. Bevorzugt ist Vinyl-1-butylether.

Als Comonomere ($a_{13}$) geeignete Acrylsäureester, Methacrylsäureester, Acrylsäureamide und Methacrylsäureamide sind hierbei insbesondere solche der allgemeinen Formel V

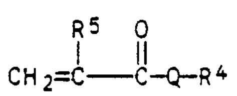

V,

worin $R^5$ eine Methylgruppe oder ein Wasserstoffatom bezeichnet und worin $R^4$ einen Alkyl- oder Cycloalkylrest mit 1 bis 10 C-Atomen oder einen ω-Methyl-poly(alkylenoxid)-α-oxyl-Rest darstellt und Q ein Sauerstoffatom oder eine $NR^6$-Gruppe mit $R^6$ = H oder $C_1$-$C_4$-Alkyl bezeichnet. Beispiele geeigneter Acrylsäureester, Methacrylsäureester, Acrylsäureamide und Methacrylsäureamide sind Methacrylat, Methylmethacrylat, Ethylacrylat, Ethylmethacrylat, Propylacrylat, Propylmethacrylat, n-Butylacrylat, n-Butylmethacrylat, n-Pentylacrylat, n-Pentylmethacrylat, n-Hexylacrylat, n-Hexylmethacrylat, tert.-Butylacrylat, Cyclohexylacrylat, Cyclohexylmethacrylat, 2-Ethylhexylacrylat, 2-Ethylhexylmethacrylat, Dicyclopentandienylacrylat, ω-Methyl-poly(ethylenoxid)-α-yl(meth)acrylat, ω-Methylpoly(propylen-1,2-oxid)-α-yl-(meth)acrylat, ω-Methyl-poly(propylen-1,3-oxid)-α-yl-(meth)acrylat, N-Methyl-N-butyl-methacrylamid oder N-Ethyl-N-(2-ethylhexyl)-acrylamid. Bevorzugt sind n-Butylacrylat, 2-Ethylhexylacrylat, ω-Methyl-poly(ethylenoxid)-α-yl-acrylat und Dicyclopentadienylacrylat, von denen wiederum die ersten drei besonders bevorzugt sind.

Beispiele ganz besonders bevorzugter Copolymerisate sind Ethylen/(Meth)-Acrylsäure-Copolymerisate, die n-Butylacrylat, 2-Ethylhexylacrylat und/oder ω-Methyl-poly(ethylenoxid)-α-yl-acrylat als Comonomere ($a_{13}$) einpolymerisiert enthalten.

Die Copolymerisate können außerdem photopolymerisierbare Reste ($a_3$) der allgemeinen Formel VI enthalten

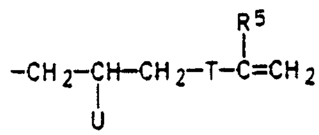

VI,

worin

U eine Hydroxy-, eine Amino- oder eine Thiolgruppe,

T eine Ester-, eine Amin-, eine Ether- oder eine $C_1$- bis $C_{10}$-Alkandiylgruppe und

$R^5$ ein Wasserstoffatom oder eine Methylgruppe bezeichnet.

Beispiele geeigneter photopolymerisierbarer olefinisch ungesättigter Reste ($a_3$) sind die
2-Hydroxy-5-oxo-4-oxahept-6-en-1-yl-,
2-Amino-5-oxo-4-oxahept-6-en-1-yl-, 2-Thiolo-5-oxo-4-oxahept-6-en-1-yl-,
2-Hydroxy-5-oxo-4-oxa-6-methylhept-6-en-1-yl-,
2-Amino-5-oxo-4-oxa-6-methylhept-6-en-1-yl-,
2-Hydroxy-5-oxo-4-azahept-6-en-1-yl-, 2-Amino-5-oxo-4-azahept-6-en-1-yl-,
2-Thiolo-5-oxo-5-azahept-6-en-1-yl-,
2-Hydroxy-5-oxo-4-aza-6-methylhept-6-en-1-yl-,
2-Hydroxy-5,10-dioxo-4,9-dioxa-6-aza-11-methyl-dodec-11-en-1-yl-,
2-Amino-5-oxo-4-aza-6-methyl-hept-6-en-1-yl-,
2-Thiolo-5-oxo-4-aza-6-methyl-hept-6-en-1-yl-,
2-Hydroxy-4-oxahex-5-en-1-yl-, 2-Amino-4-oxahex-5-en-1-yl-,
2-Thiolo-4-oxahex-5-en-1-yl-, 2-Hydroxy-hex-5-en-1-yl,
2-Amino-hex-5-en-1-yl-, 2-Thiolo-hex-5-en-1-yl-,
2-Hydroxy-hept-6-en-1-yl-, 2-Amino-hept-6-en-1-yl- oder
2-Thiolo-hept-6-en-1-yl-Reste. Bevorzugt ist der 2-Hydroxy-5-oxo-4-oxa-6-methyl-hept-6-en-1-yl-Rest VII.

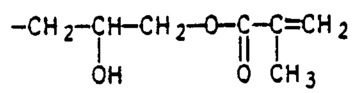

VII

Diese photopolymerisierbaren olefinisch ungesättigten Reste ($a_3$) können auch in den anderen Bindemitteln ($a_1$) vorhanden sein.

Außerdem können die Copolymerisate zusätzlich zu den photopolymerisierbaren olefinisch ungesättigten Resten ($a_3$) oder anstelle von diesen seitenständige Reste der allgemeinen Formel VIII enthalten,

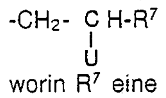

VIII,

worin $R^7$ eine polare Gruppe, ein Wasserstoffatom oder eine weitere Gruppe U bedeutet.

Unter polaren Gruppen werden solche Gruppen verstanden, welche zur Dipol-Dipol-, Dipol-Ion- oder Ion-Ion-Wechselwirkung befähigt sind.

Beispiele geeigneter Reste der allgemeinen Formel VIII sind 2-Hydroxy-eth-1-yl-, 2-Amino-eth-1-yl-, 2-Thiolo-eth-1-yl-, 2,3-Dihydroxi-prop-1-yl- 2-Amino-3-hydroxy-prop-1-yl, 2-Thiolo-3-hydroxy-prop-1-yl- oder 2-Hydroxy-2-[ω-alkyl-poly(ethylenoxid)-α-yl]-eth-1-yl-Reste.

Die neue photopolymerisierbare Aufzeichnungsschicht (A) enthält, bezogen auf ihre Gesamtmenge 0,001 bis 10, vorzugsweise 0,1 bis 7, vorteilhafterweise 0,2 bis 5 und insbesondere 0,3 bis 4 Gew.% eines oder mehrerer Photopolymerisationsinitiatoren ($a_2$), wobei diese Menge mitbestimmt wird von der Menge an mitverwendeten Komponenten ($a_3$).

Beispiele geeigneter Photopolymerisationsintiatoren ($a_2$) sind Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethyl-acetal; oder Acylarylphosphinoxide, wie 2-Dimethoxibenzoyl-diphenylphosphinoxid, 2,4,6-Trimethylbenzoyl-diphenylphosphinoxid, 2,4,6-Trimethylbenzoylphenylphosphinsäureethylester oder 2,4,6-Trimethylbenzoyl-phenylphosphinsäure-Natrium-Salz oder substituierte oder unsubstituierte Chinone, wie Ethylanthrachinon, Benzathrachinon, Benzophenon oder 4,4′-Bis-(dimethylamino)benzophenon. Sie können allein oder im Gemisch miteinander oder in Verbindung mit Coinitiatoren verwendet werden, z.B. Ethylanthrachinon mit 4,4′-Bis-(dimethylamino)benzophenon, Benzoinmethylether mit Triphenylphosphin, Diacylphosphinoxide mit tertiären Aminen oder Acylarylphosphinoxide mit Benzildimethylacetal.

Die neue photopolymerisierbare Aufzeichnungsschicht (A) enthält photopolymerisierbare olefinisch ungesättigte Bestandteile ($a_3$). Bei diesen handelt es sich im photopolymerisierbare olefinisch ungesättigte Verbindungen (Monomere) ($a_3$), welche mit dem Bindemittel ($a_1$) verträglich sind oder es handelt sich um die vorstehend bei den polymeren Bindemitteln ($a_1$) beschriebenen, photopolymerisierbaren olefinisch ungesättigten Reste ($a_3$), welche seitenständig oder endständig mit den polymeren Bindemitteln ($a_1$) verknüpft sind.

Die Monomeren ($a_3$) und die photopolymerisierbaren olefinisch ungesättigten Reste ($a_3$) liegen beide gemeinsam in der neuen Aufzeichnungsschicht (A) vor, wobei ihr Mengenverhältnis breit variieren kann. Zusammen sind sie in der neuen photopolymeren Aufzeichnungsschicht (A), bezogen auf deren Gesamtmenge, zu 0,5 bis 60, vorzugsweise 2 bis 30 und insbesondere 2 bis 15 Gew.% enthalten.

Indes können in der neuen photopolymerisierbaren Aufzeichnungsschicht (A) entweder nur die Monomeren ($a_3$) oder nur die photopolymerisierbaren olefinisch ungesättigten Reste ($a_3$) vorliegen.

Sofern die neue photopolymerisierbare Aufzeichnungsschicht (A) nur photopolymerisierbare olefinisch ungesättigte Reste ($a_3$) enthält, liegt deren Menge bei 0,5 bis 60, vorzugsweise 2 bis 30 und insbesondere 2 bis 15 Gew.% der neuen photopolymerisierbaren Aufzeichnungsschicht (A).

Sofern die neue photopolymerisierbare Aufzeichnungsschicht (A) nur Monomere ($a_3$) enthält, liegt deren Menge bei 0,5 bis 60, vorzugsweise 2 bis 30 und insbesondere 2 bis 15 Gew.% der neuen photopolymerisierbaren Aufzeichnungsschicht (A).

Geeignete Monomere ($a_3$) besitzen im allgemeinen einen Siedepunkt von über 100 °C bei Atmosphärendruck und ein Molgewicht von bis zu 3000, insbesondere von bis zu 2000. Im allgemeinen handelt es sich bei den geeigneten Monomeren ($a_3$) um Ester der Acrylsäure und der Methacrylsäure, um Styrol und dessen Derivate, um Ester der Fumarsäure und der Maleinsäure, um Vinylester, um Vinylether, um Acryl- und Methacrylamide und um Allylverbindung. Voraussetzung für ihre Verwendbarkeit ist, daß sie die anspruchsgemäße Bedingung der Verträglichkeit mit dem Bindemittel ($a_1$) erfüllen.

Beispiele besonders gut geeigneter Monomerer ($a_3$), welche einen besonders vorteilhaften Effekt zur Folge haben, sind Butylacrylat, Butylmethacrylat, 2-Ethylhexylacrylat, Lauryl(meth)acrylat, Ethylenglykol-di-(meth)acrylat, Butandiol-1,4-di(meth)acrylat, Neopentylglykol-di(meth)acrylat, 3-Methylpentandiol-di(meth)-acrylat, 2-Hydroxypropyl(meth)acrylat, 2-Hydroxyethyl(meth)acrylat, 1,6-Hexandiol-di(meth)acrylat, 1,1,1-Trimethylolpropan-tri(meth)acrylat, Di-, Tri- und Tetraethylenglykol-di(meth)acrylat, Tripropylenglykol-di-(meth)acrylat oder Pentaerythrit-tetra(meth)acrylat, Poly(ethylenoxid)-di-(meth)acrylat, ω-Methyl-poly-(ethylenoxid)-α-yl-(meth)acrylat, N-N-Diethylaminoethylacrylat ein Umsetzungsprodukt aus 1 Mol Glycerin, 1 Mol Epichlorhydrin und 3 Mol Acrylsäure, Isobornylacrylat, Isobornylmethacrylat, Dihydrodicyclopentadienylacrylat, Dihydrodicyclopentadienylmethacrylat, Hex-1-en-6-yl-acrylat, Hex-1-en-6-yl-methacrylat, Dihydroxylimonendiacrylat, Dihydroxylimonendimethacrylat, Dicyclopentyldimethylendiacrylat, Dicyclopentyldimethylendimethacrylat, Thio-diethylenglykoldiacrylat, Thio-diethylenglykol-dimethacrylat, Benzylacrylat, Benzylmethacrylat, Dodecandiol-diacrylat, Dodecandiol-dimethacrylat, Fumarsäure-di-butylester, Fumarsäure-di-n-octylester, Divinylbenzhol, Vinyloleat, Octadeacylvinylether, Butandiol-1,4-divinylether, Diallylphthalat oder Itaconsäurebisallylester.

Die neue photopolymerisierbare Aufzeichnungsschicht (A) kann neben den erfindungswesentlichen Lecithinen I und/oder II (= Hilfsstoffe $a_{41}$) einen oder mehrere weitere Hilfsstoffe ($a_4$) enthalten, mit deren Hilfe das anwendungstechnische Eigenschaftsprofil der neuen Schicht (A) der erfindungsgemäßen Aufzeichnungsmaterialien und der hieraus hergestellten Druck- und Reliefformen variiert werden kann.

Hierbei handelt es sich vor allem um Weichmacher, Inhibitoren der thermisch initiierten Polymerisation, Farbstoffe, Pigmente, photochrome Zusätze, Mittel zur Verbesserung der Reliefstruktur, Vernetzungshilfsmittel, Antioxidanten, Antizonantien, Füllstoffe, Flußmittel oder Formtrennmittel. Die Menge dieser gegebenenfalls vorhandenen weiteren Hilfsstoffe ($a_4$) zuzüglich der Menge der erfindungswesentlichen Lecithine I und/oder II (Hilfsstoffe $a_4$) soll im allgemeinen 40 Gew.% der neuen photopolymerisierbaren Aufzeichnungsschicht nicht übersteigen.

Beispiele für Weichmacher sind modifizierte und unmodifizierte Naturöle und -harze, wie paraffinische oder naphtenische Öle sowie Erdölharze oder Pentaerylthritolester von hydriertem Kollophonium; Alkyl-, Alkenyl-,

Arylalkyl- oder Arylalkenylalkoholester von Säuren, wie Zitronensäure, Essigsäure, Propionsäure, Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze, wie Oligostyrol, oligomere Styrol-Butadien-Copolymerisate, Oligo-α-methylstyrol, oligomere α-Methylstyrol/p-Methylstyrol-Copolymerisate, flüssige 1,2- oder 1,4-Oligobutadiene, Oligopentadiene, flüssige oligomere Acrylnitril-Butadien-Copolymerisate, Polyoctenamere eines Molekulargewichts von $10^3$ bis $1,2.10^5$, worunter bekanntermaßen Macrocyclen aus Poly(octenylen) zu verstehen sind; sowie Polyterpen-, Polyacrylat-, Polyester- oder Polyurethanharze, synthetische Polymere, wie Polyethylen oder Ethylen/Propylen/Dien-Kautschuke; ω-Methyl-oligo-(ethylenoxid); oder Sulfonamide. Von Vorteil sind Mengen von 1 bis 25 Gew.%, bezogen auf die neue photopolymerisierbare Aufzeichnungsschicht (A).

Inhibitoren der thermisch initiierten Polymerisation können im allgemeinen in einer Menge von 0,001 bis 2 Gew.%, bezogen auf die neue photopolymerisierbare Aufzeichnungsschicht (A), zugesetzt werden. Sie weisen keine nennenswerte Eigenabsorption in dem aktinischen Bereich auf, in dem der Photopolymerisationsinitiator ($a_2$) absorbiert. Beispiele für Inhibitoren sind Hydrochinon, p-Methoxiphenol, 2,6-Di-tert.-butyl-p-kresol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040) oder N-Nitrosamine, wie N-Nitrosodiphenylamin, oder die Salze, beispielsweise die Kalium, Calcium- oder Aluminiumsalze, des N-Nitrosocyclohexylhydroxylamins.

Farbstoffe, Pigmente oder photochrome Zusätze können der neuen photopolymerisierbaren Aufzeichnungsschicht (A) in einer Menge von 0,0001 bis 2 Gew.% bezogen auf die neue photopolymerisierbare Aufzeichnungsschicht (A), zugesetzt werden. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist es, daß sie - ebenso wie die Inhibitoren der thermisch initiierten Polymerisation - die Photopolymerisation nicht stören. Geeignet sind z.B. die löslichen Phenazinium-, Phenoxazinium-, Acridinium- und Phenothiaziniumfarbstoffe. Diese Farbstoffe werden auch zusammen mit einer hinreichenden Menge eines Reduktionsmittels verwendet, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexylhydroxyl amins, vorzugsweise die Kalium-, Calcium- und Aluminiumsalze. Letztere können, wie erwähnt, zugleich als Inhibitoren der thermisch initiierten Polymerisation dienen. Die Reduktionsmittel werden im allgemeinen in Mengen von 0,005 bis 5 Gew.%, bezogen auf die neue photopolymerisierbare Aufzeichnungsschicht (A) zugesetzt, wobei sich in vielen Fällen der Zusatz eines 3- bis 10fachen der Menge an mitverwendetem Farbstoff bewährt hat.

Beispiele für Vernetzungshilfsmittel sind die üblichen und bekannten tri-und tetrafunktionellen Thiolverbindungen.

Beispiele für Antioxidanten sind sterisch gehinderte Monophenole, wie 2,6-Di-tert.-butyl-p-kresol; alkylierte Thiobis- und Alkylidenbisphenole, wie 2,2′-Methylen-bis-(4-methyl-6-tert.-butylphenol) oder 2,2′-Bis-(1-hyxdroxy-4-methyl-6-tert.-butylphenyl)sulfid; Hydroxybenzyle, wie 1,3,5-Trimethyl-2,4,6-tris-(3,5-di-tert.-butyl-4-hydroxybenzyl)benzol; Triazine, wie 2-(4-Hydroxy-3,5-tert.-butylanilino)-4,6-bis-(n-octylthio)-1,3,5-triazin; polymerisiertes Trimethyldihydrochinon; Zinkbutyldithiocarbamat; Dilaurylthiodipropionat; oder Phosphite, wie Tris(nonylphenyl)phosphit. Von Vorteil sind Mengen 0,0001 bis 5 Gew.% bezogen auf die neue photopolymerisierbare Aufzeichnungsschicht (A).

Beispiele für nicht molekulardispers einmischbare, polymere oder nicht polymere organische und anorganische Füllstoffe oder Verstärkungsfüllstoffe sind solche, die für die Wellenlängen des zur Belichtung der erfindungsgemäßen Gemische verwendeten Lichts im wesentlichen durchlässig sind, dieses nicht streuen und in ihrem Brechungsindex weitgehend dem betreffenden Gemisch angepaßt sind, wie etwa Polystyrol, organophiles Siliciumdioxid, Bentonit, Kieselsäure, ®Aerosil, organophiles Aluminiumoxid, Glaspulver, kolloidaler Kohlenstoff sowie verschiedene Arten von Farbstoffen und Pigmenten. Diese Hilfsstoffe

werden in Mengen verwendet, die mit den gewünschten Eigenschaften der erfindungsgemäßen Aufzeichnungsmaterialien variieren. Die Füllstoffe haben den Vorteil, daß sie die Festigkeit der neuen photopolymerisierbaren Aufzeichnungsschicht (A) und der hieraus hergestellten Reliefschicht (A′) sowie deren Abriebfestigkeit verbessern, deren Klebrigkeit verringern und unter Umständen hierin als farbgebende Mittel wirksam sind.

Ein Beispiel für ein Flußmittel ist Calciumstearat.

Ein Beispiel für ein Formtrennmittel ist Talkum.

Beispiele für Antiozonantien sind die üblichen und bekannten Ozonschutzwachse sowie die Chloralkane (Chlorparaffine) mit 8 bis 40 Kohlenstoffatomen und 30 bis 73 Gew.% Chlor im Molekül.

Die Dicke der neuen photopolymerisierbaren Aufzeichnungsschicht (A) richtet sich in erster Linie nach dem Verwendungszweck der erfindungsgemäßen Aufzeichnungsmaterialien: So variiert die Dicke im allgemeinen von 0,001 bis 7, vorzugsweise 0,1 bis 7 und insbesondere 0,7 bis 6,5 mm, weil die Druck- und Reliefformen, welche man aus den erfindungsgemäßen Aufzeichnungsmaterialien mit neuen photopolymerisierbaren Aufzeichnungsschichten (A) dieser Dicke hergestellt hat, für die Mehrzahl der Drucktechniken sowie für die Photoresisttechnik geeignet sind.

Außer der neuen photopolymerisierbaren Aufzeichnungsschicht (A) kann das erfindungsgemäße Aufzeichnungsmaterial weitere Schichten enthalten, welche für seine Funktion von Nutzen sind.

So kann die neue photopolymerisierbare Aufzeichnungsschicht (A) mit einem dimensionsstabilen Träger (B) haftfest oder leicht ablösbar verbunden sein. Der dimensionsstabile Träger (B) wiederum kann mit einer weichelastischen Unterschicht (US) unterlegt sein. Ferner kann eine haftfeste Verbindung zwischen dem Träger (B) und der neuen Schicht (A) mit Hilfe einer Haftschicht (HS) erreicht werden. Sofern der Träger (B) mit der neuen Schicht (A) leicht ablösbar verbunden ist, wird er auch als temporärer Schichtträger (B) bezeichnet.

Als dimensionsstabile Träger (B) können Platten, Folien oder konische oder zylindrische Röhren (sleeves) aus Metallen, wie Stahl, Aluminium, Kupfer oder Nickel oder aus Kunststoffen, wie Polyethylenterephthalat, Polybutylenterephthalat, Polyamid oder Polycarbonat verwendet werden. Daneben kommen noch Gewebe und Vliesse, z.B. Glasfasergewebe oder Verbundmaterialien aus z.B. Glasfasern und Kunststoffen wie Polyethylenterephthalat in Frage. Daneben kommen als Träger (B) auch Platten in Betracht, wie sie üblicherweise bei der Herstellung von Leiterplatten verwendet werden.

Als Haftschichten (HS) werden mit Vorteil übliche und bekannte, etwa 0,5 bis 40 µm dicke Haftlackschichten verwendet.

Werden als Träger (B) stark reflektierende Platten oder Folien verwendet, dann können sie geeignete Lichthofschutzmittel, wie Ruß oder Mangandioxid enthalten. Die Lichthofschutzmittel können aber auch als separate Schicht auf dem Träger (B) aufgetragen werden oder in der Haftschicht (HS) oder in der neuen Schicht (A) enthalten sein.

Außerdem kann das erfindungsgemäße Aufzeichnungsmaterial eine lichtdurchlässige, in den Entwickler Lösungsmitteln für die neue photopolymerisierbaren Aufzeichnungsschicht (A) lösliche oder quellbare, glatte oder mattierte, nicht klebrige Deckschicht (C) enthalten, welche an der neuen photopolymerisierbaren Aufzeichnungsschicht (A) fester haftet als an einer gegebenenfalls vorhandenen Deckfolie (D) und welche von einem reißfeste Filme bildenden Polymeren und den gegebenenfalls darin enthaltenen Zusatzstoffen gebildet wird.

Beispiele geeigneter, reißfeste Filme bildender Polymere sind Polyamide, Copolyamide, Polyurethane, Poly(meth)acrylate, Polyvinylalkohol-alkancarbonsäureester eines Hydrolysegrades von 30 bis 99 %, Cyclokautschuke hohen Cyclisierungsgrades, Ethylen-Propylen-Copolymerisate, Homo- und Copolymerisate des Vinylchlorids oder Ethylen-Vinylacetat-Copolymerisate.

Beispiele geeigneter Deckschichten (C), welche Zusatzstoffe enthalten, sind aus der US-A-4 162 919, der DE-A-28 23 300, der DE-B-21 23 702, der US-A-4 072 527 oder der US-A-3 453 311 bekannt.

Beispiele besonders gut geeigneter Deckschichten (C), welche Zusatzstoffe enthalten, werden in der deutschen Patentanmeldung P 37 36 980.6 (O.Z. 0050/39548) beschrieben.

Im allgemeinen sind die Deckschichten 0,2 bis 25 µm dick.

Desweiteren kann das erfindungsgemäße Aufzeichnungsmaterial eine Deckfolie (D) enthalten, welche sich von der neuen photopolymerisierbaren Aufzeichnungsschicht (A) oder von der Deckschicht (C) leicht ablösen läßt.

Die Deckfolien (D) sind 10 bis 250, insbesondere 20 bis 150 µm dick. Sie bestehen im wesentlichen aus Kunststoffen, textilen Stoffen, Papieren oder Metallen. Diejenige Oberfläche der Deckfolien (D), welche der Deckschicht (C) unmittelbar aufliegt, ist glatt, d.h., sie weist einen Oberflächenrauhwert $R_{max} \leq 0,1$ µm auf, oder sie ist mattiert, d.h., sie hat einen Oberflächenrauhwert $R_{max}$ zwischen 0,1 und 15, vorzugsweise 0,3 bis 10, und insbesondere 0,5 bis 7 µm. Sofern die Deckfolie (D) mattiert ist, prägt sich ihr

Rauhheitsmuster in die Deckschicht (C) und ggf. auch noch in die Oberfläche der neuen photopolymerisierbaren Aufzeichnungsschicht (A) ein. Diese glatte oder matte Oberfläche der Deckfolie (D) kann außerdem antihaftend ausgerüstet sein, d.h., sie kann beispielsweise eine 0, 1 bis 0,5 µm dicke Antihaftschicht (AS) aus üblichen und bekannten Silikonen oder aus anderen Kunststoffen, wie etwa Polyethylen oder Polypropylen aufweisen. Deckfolien (D) aus textilen Stoffen oder Papieren können zudem mit Kunststoffen wie Harnstofformaldehyd oder Polyolefinen imprägniert sein. Deckfolien (D) aus Kunststoffen können überdies biaxial gereckt sein. Hierbei ist es oftmals von Vorteil, vor der biaxialen Reckung eine 0,1 bis 0,5 µm dicke Schicht aus beispielsweise einem Vinylidenchloridcopolymerisat auf derjenigen Seite der Deckfolie (D) aufzutragen, welche später der Deckschicht (C) oder der neuen photopolymerisierbaren Aufzeichnungsschicht (A) direkt aufliegt.

Beispiele besonders vorteilhafter Deckfolien (D) sind 20 bis 150 µm dicke, glatte oder mattierte, biaxial gereckte oder ungereckte, ggf. antihaftend ausgerüstete Kunststoffolien aus Polyethylen, Polypropylen, Polyamid, Polystyrol, Styrol/Acrylnitril-Copolymerisaten oder aus Polymethylmethacrylat; oder aus Copolymerisaten von Methylmethacrylat mit Methacrylsäure, Acrylsäure, Methylacrylat oder mit Butylacrylat; oder aus Polyvinylchlorid, Polyvinylacetat, Vinylchlorid/Vinylacetat-Copolymerisaten, Polyvinylalkohol, Polyvinylpyrrolidon, Polycarbonat, Celluloseester, wie etwa Celluloseacetatsuccinat, oder aus Polyethylenterephthalat, von denen Deckfolien (D) aus Polyethylenterephthalat ganz besonders vorteilhaft sind.

Die Herstellung des erfindungsgemäßen Aufzeichnungsmaterials weist keine technischen Besonderheiten auf, sondern erfolgt nach den üblichen und bekannten Methoden der Herstellung lichtempfindlicher Schichten und Deckschichten sowie nach den üblichen und bekannten Methoden der Herstellung von Folien aus Kunststoffen, textilen Stoffen, Papieren oder Metallen.

So werden die neuen photopolymerisierbaren Aufzeichnungsschichten (A) üblicherweise durch das Mischen der vorstehend beschriebenen Bestandteile ($a_1$), ($a_2$), ($a_3$), ($a_{41}$) und gegebenenfalls ($a_4$) mittels der üblichen Knet-, Misch- und Lösungstechniken und durch Formen der hierbei resultierenden Gemische (A) mittels Gießen aus Lösung, Heißpressen, Kalandrieren oder Extrudieren hergestellt. Sofern die erfindungsgemäßen Aufzeichnungsmaterialen lediglich aus der neuen photopolymerisierbaren Aufzeichnungsschicht (A) bestehen, ist mit deren Herstellung das Herstellverfahren insgesamt abgeschlossen. Hierbei ist das Verfahren zur Herstellung der neuen photopolymerisierbaren Aufzeichnungsschicht (A) ein wesentlicher Schritt im erfindungsgemäßen Verfahren zur Verbesserung der Reliefstruktur von Druck- und Reliefformen.

Enthalten die erfindungsgemäßen Aufzeichnungsmaterialien weitere Schichten, sind weitere Arbeitsgänge durchzuführen, welche in das Verfahren zur Herstellung mehrschichtiger erfindungsgemäßer Aufzeichnungsmaterialien integriert sind oder separat hiervon durchgeführt werden.

So wird die Deckschicht (C) üblicherweise nach den Methoden hergestellt, wie sie auch für die Darstellung der neuen photopolymerisierbaren Aufzeichnungsschicht (A) in Betracht kommen.

Die Bestandteile der Deckfolien (D) werden gleichfalls mittels der üblichen Knet-, Misch- und Lösungstechniken vermengt und durch Gießen aus Lösung, Heißpressen, Kalandrieren oder Extrudieren und Blasformen zu den entsprechenden Folien geformt. Auch diese Arbeitsgänge können in das Verfahren zur Herstellung der erfindungsgemäßen Aufzeichnungsmaterialien integriert sein, üblicherweise werden indes die Deckfolien (D) separat hergestellt, auf Rollen aufgewickelt und in dieser Form für die Herstellung mehrschichtiger erfindungsgemäßer Aufzeichnungsmaterialien angewendet.

Auch die Herstellung mehrschichtiger erfindungsgemäßer Aufzeichnungsmaterialien weist keine technischen Besonderheiten auf, sondern erfolgt in üblicher Weise durch Verbinden der neuen photopolymerisierbaren Aufzeichnungsschicht (A) mit der Deckschicht (C) und der Deckfolie (D), wobei dies auch auf einem dimensionsstabilen Träger (B) ggf. unter Mitverwendung einer Haftschicht (HS) und einer weichelastischen Unterschicht (US) erfolgen kann. Hierbei ist es grundsätzlich möglich, die neue photopolymerisierbaren Aufzeichnungsschicht (A) zuerst mit dem Träger (B) zu verbinden und anschließend ihre unbedeckte Seite mit der Deckschicht (C) und der Deckfolie (D) zu bedecken, oder aber die neue photopolymerisierbaren Aufzeichnungsschicht (A) wird zunächst auf die mit der Deckschicht (C) überzogene Deckfolie (D) aufgetragen und dann erst mit dem Träger (B) verbunden.

Die erfindungsgemäßen, gegebenenfalls mehrschichtigen Aufzeichnungsmaterialien weisen besondere Vorteile auf: So sind sie mittels der üblichen und bekannten Methoden herzustellen und erfordern somit keine Umbauten bereits vorhandener Anlagen und Apparaturen oder gar Neuinvestitionen in neue, speziell zu entwickelnde Anlagen und Apparaturen. Sie sind dimensionsstabil und neigen nicht zum kalten Fließen oder zum Ausschwitzen darin enthaltener Komponenten. Sie können daher bedenkenlos transportiert und längere Zeit gelagert werden, ohne daß es hierbei zu einer Beschädigung kommt.

Die besonderen Vorteile der erfindungsgemäßen, gegebenenfalls mehrschichtigen Aufzeichnungsmaterialien treten bei ihrer Verwendung für die Herstellung von dekorativen Relief-, Hochdruck-, Flexodruck-, Offsetdruck- und Tiefdruckformen sowie von Photoresists, insbesondere aber von Hochdruck- und Flexodruckformen in überzeugender Weise zu Tage. Dabei umfaßt die Herstellung der dekorativen Relief-, Hochdruck-, Flexodruck-, Offsetdruck- und Tiefdruckformen sowie der Photoresists aus den erfindungsgemäßen, ggf. mehrschichtigen Aufzeichnungsmaterialien üblicherweise die folgenden Arbeitsgänge:

(i) ggf. Vorbehandeln der erfindungsgemäßen Aufzeichnungsmaterialien,

(ii) ggf. Ablösen der Deckfolie (D) von der ggf. vorhandenden Deckschicht (C) oder von der neuen photopolymerisierbaren Aufzeichnungsschicht (A),

(iii) Auflegen einer Bildmaske oder Negativvorlage auf die neue photopolymerisierbaren Aufzeichnungsschicht (A) oder auf die ggf. vorhandene Deckschicht (C),

(iv) bildmäßiges Belichten der neuen photopolymerisierbaren Aufzeichnungsschicht (A) mit aktinischem Licht einer Wellenlänge $\lambda$ zwischen 230 und 450, insbesondere 350 und 450 nm,

(v) Auswaschen (Entwickeln) der unbelichteten Bereiche der bildmäßig belichteten Aufzeichnungsschicht (A) mittels geeigneter Entwicklerlösungsmittel, wobei auch die ggf. vorhandene Deckschicht (C) weggewaschen wird, und

(vi) Trocknen sowie

(vii) ggf. Nachbehandeln der in dieser Weise erhaltenen dekorativen Relief-, Hochdruck-, Flexodruck- und Tiefdruckform sowie Photoresists, welche nun die photopolymerisierte Reliefschicht ($A'$) enthalten oder aus dieser bestehen.

Diese Verfahrensschritte sind integraler Bestandteil des erfindungsgemäßen Verfahrens zur Verbesserung der Reliefstruktur von dekorativen Relief-, Hochdruck-, Flexodruck-, Offsetdruck- und Tiefdruckformen sowie von Photoresists.

Die Dicke der photopolymerisierten Reliefschicht ($A'$) variiert je nach Anwendungszweck der Druck- und Reliefformen von 0,001 bis 7, vorzugsweise 0,1 bis 7 und insbesondere 0,7 bis 6,5 mm.

Eine übliche Methode der Vorbehandlung ist die vollflächige Belichtung der neuen photopolymerisierbaren Aufzeichnungsschicht (A) von ihrer Rückseite her mit aktinischem Licht. Unter Rückseite ist hierbei die Seite zu verstehen, welche der später gebildeten photopolymerisierten Reliefschicht ($A'$) abgewandt ist.

Geeignete Lichtquellen für aktinisches Licht sind handelsübliche UV-Fluoreszenzröhren, Quecksilbermittel-, -hoch- und -niederdruckstrahler, superaktinische Leuchtstoffröhren, Xenon-Impulslampen, mit Metalliodiden dotierten Lampen Kohlebogenlampen oder Laser wie Gaslaser.

Beispiele geeigneter organischer Entwicklerlösungsmittel sind aliphatische oder aromatische Kohlenwasserstoffe, wie n-Hexan, n-Heptan, Octan, Petrolether, Ligroin, Limonen oder andere Terpene, Toluol, Xylol, Ethylbenzol oder Isopropylbenzol oder Gemische aus diesen Lösungsmitteln; Ketone, wie Aceton oder Methylethylketon; Ether, wie Di-n-butylether; Ester, wie Essigsäureethylester oder Acetessigsäureethylester; halogenierte aliphatische Kohlenwasserstoffe, wie Methylenchlorid, Chloroform, Trichlorethane, Tetrachlorethylen, Dichlortetrafluorethane oder Trichlortrifluorethane; oder Gemische, die zwei oder mehr dieser Lösungsmittel enthalten; oder Gemische, die eines oder mehrere dieser Lösungsmittel und zusätzlich noch Alkohole, wie Methanol, Ethanol, Isopropanol oder n-Butanol enthalten; oder Lösungsmittel und Gemische der genannten Art, die zusatzlich feste, flüssige oder gasförmige organische und anorganische Verbindungen, wie etwa Tenside, in untergeordenten Mengen enthalten.

Beispiele geeigneter wäßrig-alkoholischer Entwicklerlösungsmittel sind wäßrige Lösungen von Methanol, Ethanol, Isopropanol oder n-Butanol, welche zusätzlich noch feste, flüssige oder gasförmige organische und anorganische Verbindungen, wie etwa Tenside, Komplexbildner, Salze, Alkalilaugen, Ammoniak oder Amine, in untergeordneten Mengen enthalten können.

Beispiele geeigneter wäßrig-alkalischer Entwicklerlösungsmittel sind wäßrige Lösungen von Lithium-, Natrium- oder Kaliumhydroxid oder von Lithium-, Natrium oder Kaliumcarbonat oder -hydrogencarbonat oder von Ammoniak, welche zusätzlich noch feste, flüssige oder gasförmige organische und anorganische Verbindungen, wie etwa Tenside, Komplexbildner oder Salze, in untergeordneten Mengen enthalten können.

Ein weiteres geeignetes Entwicklerlösungsmittel ist Wasser.

Übliche Methoden der Nachbehandlung der photopolymerisierten Reliefschicht ($A'$) sind das vollflächige Nachbelichten mit aktinischem Licht einer Wellenlänge $\lambda$ zwischen 150 und 450 nm, das Nachbelichten mit sichtbarem Licht oder das Behandeln mit halogenhaltigen Lösungen.

Werden die erfindungsgemäßen, ggf. mehrschichtigen Aufzeichnungsmaterialien diesem Verfahren unterzogen, erweisen sie sich als

- rasch belichtbar, wobei ihr Belichtungsspielraum ausgesprochen groß ist,
- detailgetreu in der Wiedergabe auch der feinsten und daher kritischen Bildmotive der Bildmasken oder Negativvorlagen, wobei sie außerdem noch eine hervorragende Relieffeinstruktur, die sich insbesondere an den Zwischentiefen bemerkbar macht, aufweisen, und als
- ausgesprochen auswaschstabil, so daß die Entwicklungsbedingungen zwecks Verkürzung der Entwicklungszeiten bedenkenlos verschärft werden können.

Dadurch verkürzen sich die Taktzeiten bei der Herstellung von dekorativen Relief-, Hochdruck-, Flexodruck-, Offsetdruck- und Tiefdruckformen sowie von Photoresists, was für die betriebliche Praxis ein erheblicher Vorteil ist.

Dieser Vorteil fällt insbesondere bei der Herstellung von Druckformen ins Gewicht.

Die besonderen Vorteile der erfindungsgemäßen Aufzeichnungsmaterialien sind damit nicht erschöpft, sondern sie manifestieren sich besonders überzeugend in den Druckformen und den Photoresists, welche man in der vorstehend beschriebenen Weise hergestellt hat:

So können die neuen Photoresists mit Vorteil für die Herstellung von Leiterplatten verwendet werden. Die neuen Druckformen, lassen sich auf Druckzylinder aufbringen und in dieser Form hervorragend für den Endlosdruck verwenden, wobei sie exzellente Drucke in besonders hoher Auflage liefern.

## Beispiele

### Beispiele 1 bis 4

Die Herstellung erfindungsgemäßer Aufzeichnungsmaterialien und ihre Weiterverarbeitung zu neuen Druckformen.

### Allgemeine Versuchsvorschrift:

#### Methode I

Für die Herstellung der neuen photopolymerisierbaren Aufzeichnungsschicht (A) wurde das Bindemittel ($a_1$) gleichmäßig in einen Zweischneckenentgasungsextruder eingetragen und bei 140 bis 180 °C aufgeschmolzen. Die flüssigen und/oder gelösten Bestandteile ($a_2$), ($a_3$), ($a_{4'}$) und ggf. ($a_4$) der neuen photopolymerisierbaren Aufzeichnungsschicht (A) wurden nacheinander in den Extruder gepumpt und dort mit der Schmelze des Bindemittels ($a_1$) vermischt. Das hierbei resultierende photopolymerisierbare Gemisch (A) wurde aus einer Breitschlitzdüse ausgetragen und von dort direkt in den Spalt eines Kalanders geleitet, wo es zu einer neuen photopolymerisierbaren Aufzeichnungsschicht (A) geformt und zugleich auf seiner einen Seite mit einer 5 µm dicken Deckschicht (C) und einer mattierten 125 µm dicken Polyethylenterephthalatfolie (Deckfolie D) und auf seiner anderen Seite über eine 5 µm dicke Haftlackschicht (HS) mit einer 125 µm dicken Polyethylenterephthalatfolie als dimensionsstabilem Schichtträger (B) haftfest verbunden wurde.

Das hierbei resultierende erfindungsgemäße mehrschichtige Aufzeichnungsmaterial des Aufbaus "(B), (A), (C) und (D)" wurde bis zu 3 Minuten von seiner Rückseite her durch den dimensionsstabilen Schichtträger (B) hindurch in einem Röhrenbelichter mit aktinischem Licht vollflächig belichtet. Hiernach wurde die Polyethylenterephthalatfolie (D) von der Deckschicht (C) abgezogen.

Nach dieser Vorbehandlung wurde das erfindungsgemäße mehrschichtige Aufzeichnungsmaterial durch eine übliche und bekannte, auf die Deckschicht (C) aufgelegte Testnegativvorlage hindurch während 2 bis 30 Minuten in einem handelsüblichen Flachbelichter mit aktinischem Licht bildmäßig belichtet und hiernach binnen 2 bis 20 Minuten in einem Bürstenwascher mit einem geeigneten Entwicklerlösungsmittel ausgewaschen.

Die so erhaltene Druckform wurde gegebenenfalls bis zu einer Stunde bei 20 bis 80 °C getrocknet. Hiernach wurde die neue Druckform fünfzehn Stunden lang gelagert.

Gegebenenfalls wurde die Druckform anschließend bis zu 20 Minuten vollflächig mit aktinischem Licht der Wellenlänge $\lambda$ = 250 - 400 nm nachbelichtet und/oder mit freies Halogen enthaltenden Lösungen nachbehandelt.

#### Methode II

Für die Herstellung der neuen photopolymerisierbaren Aufzeichnungsschicht (A) wurden ihre Bestandteile ($a_1$), ($a_2$), ($a_3$), ($a_{4'}$) und ggf. ($a_4$) in einem geeigneten Lösungsmittel aufgelöst. Die resultierende Lösung wurde so auf eine mit einer Antihalationslackschicht (= Lichthofschutzmittel) versehene Stahlplatte (= dimensionsstabiler Träger B) gegossen, daß nach dem Trocknen der hierbei gebildeten Naßschicht die

neue photopolymerisierbaren Aufzeichnungsschicht (A) in der gewünschten Dicke resultierte.

Das in dieser Weise erhaltene erfindungsgemäße mehrschichtige Aufzeichnungsmaterial des Aufbaus "-(B) und (A)" wurde fünfzehn Stunden lang gelagert. Hiernach wurde das erfindungsgemäße mehrschichtige Aufzeichnungsmaterial, wie bei der Methode I beschrieben, bildmäßig belichtet und entwickelt. Gegebenenfalls ging der bildmäßigen Belichtung eine vollflächige Vorbelichtung der neuen photopolymerisierbaren Aufzeichnungsschicht (A) mit aktinischem Licht voraus.

Die Tabelle 1 gibt Auskunft über die stoffliche Zusammensetzung der erfindungsgemäßen Aufzeichnungsmaterialien sowie die Art und Weise ihrer Herstellung und ihrer Weiterverarbeitung zu neuen Druckformen.

Testmethoden und Beurteilungskriterien

Die photopolymerisierten Reliefschichten (A′) der Druckformen, welche nach den Methoden I oder II hergestellt worden waren, wurden unter einem Lichtmikroskop visuell begutachtet, und es wurden ihre Zwischentiefen für Raster des Tonwertes 30 %, 50 % und 70 % [$=t_z$ (30), $t_z$ (50) und $t_z$ (70)] in µm gemessen. Wesentliche Kriterien für die Qualität der photopolymerisierten Reliefschichten (A′) waren

(i) sauber ausgebildete, steile Reliefflanken, welche frei von Unterwaschungen waren,

(ii) gerade Reliefkanten, welche frei von Kantenausbrüchen waren, und

(iii) sehr gut ausgeprägte Zwischentiefen.

Nach der visuellen Beurteilung der photopolymerisierten Reliefschichten (A′) der Druckformen wurden die Druckformen auf Druckzylinder aufgespannt und - je nach vorliegender Druckform - für den endlosen Hochdruck oder Flexodruck verwendet. Hierbei kamen die für die jeweiligen Drucktechniken üblichen und bekannten Hochdruck- oder Flexodruckmaschinen und die entsprechenden typischen üblichen und bekannten Druckfarben zur Anwendung. Entscheidendes Qualitätskriterium für die jeweils verwendete, aus einem der erfindungsgemäßen mehrschichtigen Aufzeichnungsmaterialien hergestellte neue Druckform war die hiermit erreichbare Auflage exzellenter Drucke.

Die Tabelle 2 faßt die betreffenden Versuchsergebnisse zusammen.

Vergleichsversuche V 1 bis V 4

Die Herstellung bekannter Aufzeichnungsmaterialien und ihre Weiterverarbeitung zu bekannten Druckformen.

Jedes der Beispiele 1 bis 4 wurde unter exakt vergleichbaren Bedingungen wiederholt, nur daß jeweils auf die Zugabe der erfindungswesentlichen Lecithine I und/oder II [Bestandteil ($a_4$)] verzichtet wurde. Dafür wurde der Anteil des Bestandteils ($a_3$) in der jeweils verwendeten, bekannten photopolymerisierbaren Aufzeichnungsschicht (A) um die entsprechende Menge erhöht.

Die stoffliche Zusammensetzung sowie die Art und Weise der Herstellung und der Weiterverarbeitung der bekannten Aufzeichnungsmaterialien V 1 bis V 4 finden sich gleichfalls in der Tabelle 1.

Die hiermit resultierenden Versuchsergebnisse werden in der Tabelle 2 den Versuchsergebnissen gegenübergestellt, welche mit den neuen Druckformen 1 bis 4 (Beispiele 1 bis 4) erhalten wurden.

Hierbei kann

Beispiel 1 mit Vergleichsversuch V 1,
Beispiel 2 mit Vergleichsversuch V 2,
Beispiel 3 mit Vergleichsversuch V 3 und
Beispiel 4 mit Vergleichsversuch V 4,
direkt verglichen werden.

Der Vergleich zeigt, daß die erfindungsgemäßen Aufzeichnungsmaterialien 1 bis 4 den bekannten Aufzeichnungsmaterialien V 1 bis V 4 ganz eindeutig überlegen waren. Insbesondere lieferten die erfindungsgemäßen Aufzeichnungsmaterialien 1 bis 4 Druckformen, welche erhebliche bessere photopolymerisierte Reliefschichten (A′) aufwiesen und welche höhere Auflagen an exzellenten Drucken ergaben als die bekannten. Dies untermauert den besonderen unerwarteten technischen Effekt der erfindungsgemäß zu verwendenden Lecithine I und/oder II, insbesondere aber denjenigen des Sojalecithins.

Tabelle 1: Die stoffliche Zusammensetzung sowie die Art und Weise der Herstellung und der Weiterverarbeitung erfindungsgemäßer (Beispiele 1 bis 4) und bekannter (Vergleichsversuche V 1 bis V 4) Aufzeichnungsmaterialien

| Beispiel | Methode | Stoffliche Zusammensetzung der photopolymerisierbaren Aufzeichnungsschicht (A) Bestandteile ($a_1$) (Gew.%) | ($a_2$) (Gew.%) | ($a_3$) (Gew.%) | ($a_{41}$) (Gew.%) | ($a_4$) (Gew.%) | Dicke (µm) | Weiterverarbeitung Belichtungszeit und Entwicklung | Nachbehandlung |
|---|---|---|---|---|---|---|---|---|---|
| 1 | II Methanol/Wasser(9:1) | Copolyamid aus ε-Caprolactam, Hexamethylendiammoniumadipat, 4,4'-Diaminodicyclohexylmethan und Adipinsäure (54,792) | Benzildimethylacetal (1,1) | Pentaerythrittriglycidylethertriacrylat (22,83) Phenylglycidyletheracrylat (18,264) | Sojalecithin (2,74) | N-Nitrosocyclohexylhydroxylamin-Kalziumsalz (0,274) | 500 | 6 min mit Alkohol/Wasser bei 30°C | Trocknung 80°C, 15 min |
| 2 | II Wasser | Polyvinylalkohol, Hydrolysegrad 88 % (52,379) | 2,4,6-Trimethylbenzoyl-diphenylphosphinoxid (0,427) | 2-Hydroxyethylacrylat (35,273) Butandiolmonoacrylat (10,688) | Sojalecithin (1,068) | 2,6-Di-tert.-butyl-p-kresol (0,16) Duasyn (C.I. 50240) (0,005) | 500 | 2,5 min mit Wasser bei 40°C | Trocknung 80°C, 15 min |

Tabelle 1: Die stoffliche Zusammensetzung sowie die Art und Weise der Herstellung und der Weiterverarbeitung erfindungsgemäßer (Beispiele 1 bis 4) und bekannter (Vergleichsversuche V 1 bis V 4) Aufzeichnungsmaterialien

| Beispiel | Methode | Stoffliche Zusammensetzung der photopolymerisierbaren Aufzeichnungsschicht (A) Bestandteile ($a_1$) (Gew.%) | ($a_2$) (Gew.%) | ($a_3$) (Gew.%) | ($a_{41}$) (Gew.%) | ($a_4$) (Gew.%) | Dicke (µm) | Weiterverarbeitung Belichtungszeit und Entwicklung | Nachbehandlung |
|---|---|---|---|---|---|---|---|---|---|
| 3 | II Toluol | Terpolymer aus Ethylen, Acrylsäure, und n-Butylacrylat (66,31) | Benzildimethylacetal (1,42) | Hexandioldiacrylat (11,35) | Sojalecithin (2,85) | N-Nitrosocyclohexylhydroxylamin-Kaliumsalz (0,455) Duasyn (C.I.50240) (0,005) N-Butyl-phenylsulfonamid (11,00) Propylethanolamin (6,61) | 500 | 3,5 min mit Wasser bei 60°C | Trocknung 80°C, 5 min |

Tabelle 1: Die stoffliche Zusammensetzung sowie die Art und Weise der Herstellung und der Weiterverarbeitung erfindungsgemäßer (Beispiele 1 bis 4) und bekannter (Vergleichsversuche V 1 bis V 4) Aufzeichnungsmaterialien

| Bei-spiel | Methode | Stoffliche Zusammensetzung der photopolymerisierbaren Aufzeichnungsschicht (A) Bestandteile | | | | | Dicke | Weiterverarbeitung | |
|---|---|---|---|---|---|---|---|---|---|
| | | ($a_1$) | ($a_2$) | ($a_3$) | ($a_{41}$) | ($a_4$) | | Belichtungs-zeit und Ent-wicklung | Nachbehand-lung |
| | | (Gew.%) | (Gew.%) | (Gew.%) | (Gew.%) | (Gew.%) | (µm) | | |
| 4 | I | wie Beisp. 3 | Benzildi-methyl-acetal | Methylmeth-acrylat (7,5) Glycidyl-methacry-lat | Sojale-cithin | N-Nitroso-cyclohexyl hydroxyl-amin-Ka-liumsalz (1,2 ) N-Butyl-phenylsul-fonamid (10) Duasyn (C.I.50240) (0,003) Butyletha-nolamin-(4) 2,6-Di-tert.-butyl-p-kre-sol | | 25 min<br>mit 1%iger Sodalösung bei 60°C | Trocknung 40°C, 60 min<br>Nachbelich-tung mit einer Queck-silber-Nie-derdruck-Lampe, 20 min |
| | | (68,997) | (1,0) | (5) | (1,5) | (0,8) | 2840 | | |

Tabelle 1: Fortsetzung

| Vergleichsversuch | | | |
|---|---|---|---|
| V 1 | wie Beispiel 1 | Wie Beispiel 1, nur daß kein Sojalecithin verwendet wurde und daß die Aufzeichnungsschicht zum Ausgleich 2,74 Gew.% mehr an Phenylglycidyletheracrylat ($a_3$) enthielt | wie Beispiel 1 |
| V 2 | wie Beispiel 2 | Wie Beispiel 2, nur daß kein Sojalecithin verwendet wurde und daß die Aufzeichnungsschicht zum Ausgleich 1,068 Gew.% mehr an 2-Hydroxyethylacrylat ($a_3$) enthielt | wie Beispiel 2 |
| V 3 | wie Beispiel 3 | Wie Beispiel 3, nur daß kein Sojalecithin verwendet wurde und daß die Aufzeichnungsschicht zum Ausgleich 2,85 Gew.% mehr an Hexandioldiacrylat ($a_3$) enthielt | wie Beispiel 3 |
| V 4 | wie Beispiel 4 | Wie Beispiel 4, nur daß kein Sojalecithin verwendet wurde und daß die Aufzeichnungsschicht zum Ausgleich 1,5 Gew.% mehr an Methylmethacrylat ($a_3$) enthielt. | wie Beispiel 4 |

Tabelle 2: Druckversuche

| Beispiel Nr. | Art der Druckform | Qualität der Reliefschicht (A') Reliefflanken | Reliefkanten | Zwischentiefen (µm) $t_z$ (30) | $t_z$ (50) | $t_z$ (70) | Auflage exzellenter Drucke |
|---|---|---|---|---|---|---|---|
| 1 | Hochdruck | steil, ohne Unterwaschungen | gerade, ohne Ausbrüche | 157 | 125 | 104 | $10^6$ |
| 2 | Hochdruck | steil, ohne Unterwaschungen | gerade, ohne Ausbrüche | 152 | 122 | 104 | $10^6$ |
| Vergleichsversuche | | | | | | | |
| V 1 | Hochdruck | steil, mit sehr wenigen Unterwaschungen | gerade, mit wenigen Ausbrüchen | 125 | 77 | 42 | $10^5$ |
| V 2 | Hochdruck | weniger, steil mit Unterwaschungen | rauh, mit einigen Ausbrüchen | 141 | 89 | 65 | $10^5$ |

Tabelle 2: Druckversuche

| Beispiel Nr. | Art der Druckform | Qualität der Reliefschicht (A') Reliefflanken | Reliefkanten | Zwischentiefen ($\mu m$) $t_z$ (30) | $t_z$ (50) | $t_z$ (70) | Auflage exzellenter Drucke |
|---|---|---|---|---|---|---|---|
| 3 | Hochdruck | steil, ohne Unterwaschungen | gerade, ohne Ausbrüche | 187 | 132 | 95 | $5 \cdot 10^5$ |
| 4 | Flexodruck | steil, klebfrei, ohne Unterwaschungen | gerade, ohne Ausbrüche | 160 | 105 | 92 | $> 10^6$ |
| Vergleichsversuche | | | | | | | |
| V 3 | Hochdruck | weniger steil, mit sehr wenigen Unterwaschungen | gerade, mit einigen Ausbrüchen | 85 | 45 | 22 | $10^4$ |
| V 4 | Flexodruck | weniger, steil klebrig, mit einigen Unterwaschungen | rauh | 98 | 37 | < 20 | $< 5 \cdot 10^4$ |

## Ansprüche

1. Lichtempfindliches Aufzeichnungsmaterial für die Herstellung von Druck- oder Reliefformen mit mindestens einer photopolymerisierbaren Aufzeichnungsschicht (A) aus

($a_1$) mindestens einem Polymeren als Bindemittel,

($a_2$) mindestens einem Photopolymerisationsinitiator,

($a_3$) mindestens einer photopolymerisierbaren olefinisch ungesättigten Verbindung (Monomer), welche mit dem polymeren Bindemittel ($a_1$) verträglich ist, und/oder photopolymerisierbaren olefinisch ungesättigten Resten, welche seitenständig und/oder endständig mit dem polymeren Bindemittel ($a_1$) verknüft sind, und

($a_4$) mindestens einem Hilfsstoff,

dadurch gekennzeichnet, daß seine photopolymerisierbare Aufzeichnungsschicht (A) als Hilfsstoffe ($a_4$) zumindest

($a_{41}$) ein oder mehrere Lecithine der allgemeinen Formel I und/oder II

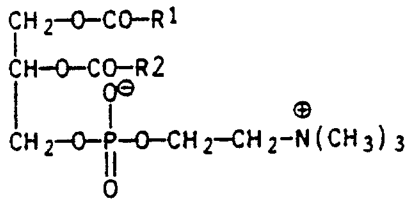

I

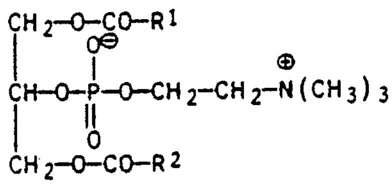

II

in einer Menge von 0,1 bis 10 Gew.-%, bezogen auf die photopolymerisierbare Aufzeichungsschicht (A), enthält, wobei in den allgemeinen Formeln I und II die Reste $R^1$ und $R^2$ gleich oder voneinander verschieden sein können und eine $C_{11}$- bis $C_{18}$-Alkylgruppe oder $C_{11}$- bis $C_{18}$-Alkenylgruppe bedeuten, mit der Maßgabe, daß zumindest einer der Reste $R^1$ oder $R^2$ eine $C_{11}$- bis $C_{18}$-Aklenylgruppe bedeutet.

2. Lichtempfindliches Aufzeichnungsmaterial nach Anspruch 1, dadurch gekennzeichnet, daß es als Lecithin ($a_{41}$) Socalecithin enthält.

3. Verwendung von Lecithinen der allgemeinen Formeln 1 und/oder II,

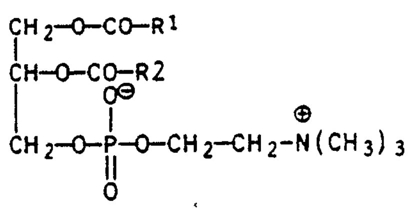

I

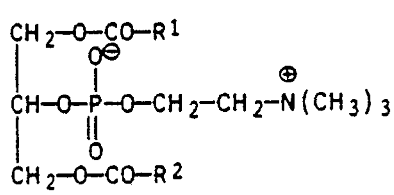

II

worin die Reste $R^1$ und $R^2$ gleich oder voneinander verschieden sein können und eine $C_{11}$- bis $C_{18}$-Alkylgruppe oder $C_{11}$- bis $C_{18}$-Alkenylgruppe bedeuten, mit der Maßgabe, daß zumindest einer der Reste $R^1$ oder $R^2$ eine $C_{11}$- bis $C_{18}$-Alkenylgruppe bedeutet, als sensitometrische Regler in photopolymerisierbaren

Aufzeichnungsschichten (A), welche im wesentlichen aus
($a_1$) mindestens einem Polymeren als Bindemittel,
($a_2$) mindestens einem Photopolymerisationsinitiator,
($a_3$) mindestens einer photopolymerisierbaren olefinisch ungesättigten Verbindung (Monomer), welche mit dem polymeren Bindemittel ($a_1$) verträglich ist, und/oder photopolymerisierbaren olefinisch ungesättigten Resten, welche seitenständig und/oder endständig mit dem polymeren Bindemittel ($a_1$) verknüpft sind, und
(a4) mindestens einem Hilfsstoff
bestehen.

4. Verwendung von Sojalecithin als sensitometrischer Regler in den photopolymerisierbaren Aufzeichnungsschichten (A), welche im wesentlichen aus
($a_1$) mindestens einem Polymeren als Bindemittel;
($a_2$) mindestens einem Photopolymerisationsinitiator,
($a_3$) mindestens einer photopolymerisierbaren olefinisch ungesättigten Verbindung (Monomer), welche mit dem polymeren Bindemittel ($a_1$) verträglich ist, und/oder photopolymerisierbaren olefinisch ungesättigten Resten, welche seitenständig und/oder endständig mit dem polymeren Bindemittel ($a_1$) verknüft sind, und
($a_4$) mindestens einem Hilfsstoff
bestehen.

5. Verfahren zur Herstellung von Druck- oder Reliefformen mit einer in ihrer Reliefstruktur verbesserten Reliefschicht (A′) aus lichtempfindlichen Aufzeichnungsmaterialien durch
(1) bildmäßiges Belichten der photopolymerisierbaren Aufzeichnungsschicht (A) von lichtempfindlichen Aufzeichnungsmaterialien mit aktinischem Licht, wodurch die belichteten Bereiche photopolymerisiert werden, und
(2) Auswaschen (Entwickeln) der unbelichteten Bereiche der bildmäßig belichteten Aufzeichnungsschicht (A) mit einem geeigneten Entwicklerlösungsmittel unter Erzeugung einer photopolymerisierten Reliefschicht (A′),
dadurch gekennzeichnet, daß man hierbei ein lichtempfindliches Aufzeichnungsmaterial gemäß einem der Ansprüche 1 oder 2 verwendet.

Europäisches Patentamt

# EUROPÄISCHER RECHERCHENBERICHT

Nummer der Anmeldung

EP 89 11 6623

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-2 027 921 (K. MAPSTONE et al.) * Zusammenfassung; Seite 1, Zeile 60 - Seite 2, Zeile 1 * --- | 1-5 | G 03 F 7/027 |
| X | US-A-3 749 592 (J.E. GASKE et al.) * Zusammenfassung; Spalte 3, Zeilen 60-69 * --- | 1-5 | |
| A,D | US-A-3 585 031 (L.P. HAYES) * Insgesamt * ----- | 1 | |
| | | | **RECHERCHIERTE SACHGEBIETE (Int. Cl.5)** |
| | | | G 03 F 7/00 |

Der vorliegende Recherchenbericht wurde für alle Patentansprüche erstellt

| Recherchenort | Abschlußdatum der Recherche | Prüfer |
|---|---|---|
| DEN HAAG | 19-12-1989 | MARKHAM R. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veroffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)